# EUROPEAN PATENT APPLICATION

(11) **EP 2 913 372 A1**
(43) Date of publication of application: **02.09.2015**
(21) Application number: 13850872.6
(22) Date of filing: 28.10.2013
(51) Int. Cl.: C09J 123/22, B32B 27/00, C09J 7/00, C09J 7/02, C09J 11/06, C09J 109/06, C09J 123/08, C09J 153/02, H01L 51/50, H05B 33/04

(54) **ADHESIVE AGENT COMPOSITION AND ADHESIVE SHEET**

(30) Priority: 29.10.2012 JP 2012237849; 28.11.2012 JP 2012259912
(71) Applicant: LINTEC Corporation, Tokyo 173-0001 (JP)
(72) Inventor: NAKAYAMA, Hidekazu, Tokyo 173-0001 (JP); UEMURA, Kazue, Tokyo 173-0001 (JP); ONO, Yoshitomo, Tokyo 173-0001 (JP); NISHIJIMA, Kenta, Tokyo 173-0001 (JP)
(74) Representative: Gille Hrabal
(86) International application number: PCT/JP2013/079120
(87) International publication number: WO 2014/069398

(57) **Abstract**

A pressure-sensitive adhesive sheet having a pressure-sensitive adhesive layer formed from a pressure-sensitive adhesive composition containing a polyisobutylene-based resin (A) having a mass-average molecular weight of 20000 or more, a styrene-based copolymer (B), and a tackifier (C) having a softening point of 135°C or less, wherein the component (B) is one or more selected from the group consisting of a styrene-butadiene-styrene triblock copolymer (SBS), a styrene-block-(ethylene-co-butylene)-block-styrene triblock copolymer (SEBS), a styrene-isobutylene diblock copolymer (SIB), and a styrene-isobutylene-styrene triblock copolymer (SIBS), has excellent adhesive force, excels in a suppressing effect on moisture intrusion, and has good transparency.

## Description

### Technical Field

The present invention relates to a pressure-sensitive adhesive composition and a pressure-sensitive adhesive sheet, and more specifically, relates to a pressure-sensitive adhesive composition and a pressure-sensitive adhesive sheet that are suitably used for sealing electronic devices, for example, display devices such as an organic EL element using electroluminescence (hereinafter, abbreviated to "EL") of an organic material.

### Background Art

In recent years, organic electronics draw attention as a technique capable of forming a display, a circuit, a battery and the like on a flexible plastic substrate at low temperature close to room temperature by adopting a coating or printing process, and research and development of various organic devices, liquid crystal displays, electronic paper, thin film transistors and the like are being advanced.

For example, an organic EL element used in organic devices has an organic layer in which an organic charge transport layer and an organic light emitting layer are laminated between an anode and a cathode, and draws attention as a light emitting element capable of high-luminance light emission by low-voltage direct current drive. In addition, since the organic EL element uses a plastic film as a substrate, it is expected as a display for achieving thinning, weight reduction, flexibilization and the like.

Now, an organic EL element has the following problem: when driven for a certain time, light emission characteristics such as light emission luminance, light emission efficiency, and light emission uniformity, etc. are deteriorated as compared with those in the initial stage. As causes for this problem, oxidation of the electrode and deteriorate of an organic substance to be caused due to oxygen, water vapor, or the like which has intruded into the organic EL element, oxidation or decomposition of an organic material to be caused due to heat at the time of drive, and the like are considered.

In addition, by the influence of oxygen or moisture (water vapor) and exposure to heat generated during the driving and high temperature during the driving, stress is generated at an interface of a structure in the organic EL element because of the difference of thermal expansion coefficients of the respective constituents, and the interface of the structure is sometimes peeled off. The foregoing mechanical degradation of the structure is considered as the causes for the degradation of the light emission characteristics.

In order to prevent the foregoing problem, for example, techniques described in the following PTL 1 to 4 have been proposed for sealing an organic EL element to prevent it from being in contact with oxygen and moisture (water vapor).

PTL 1 discloses a method of covering an organic EL layer formed on a glass substrate with a moisture-resistant photo-curable resin and fixing a substrate having a poor water-permeable property to the top of the photo-curable resin layer.

PTL 2 discloses a method of sealing facing transparent substrates with a sealing material made of fritted glass.

PTL 3 discloses a method of bonding a substrate to a shielding material with a ultraviolet curable epoxy resin adhesive agent of cationic cure-type when forming an airtight space by the two.

PTL 4 discloses a method of covering the outer surface of an organic EL element with a sealing film formed by a moisture-proof polymer film and an adherent layer.

However, according to the above-described conventional techniques, the organic light emitting layer and the charge transport layer may be thermally degraded due to heating in the sealing step, and since a large quantity of ultraviolet irradiation is required for curing when using the photo-curable resin adhesive agent, the organic light emitting layer and the charge transport layer may be degraded. In addition, when the sealing material is a cured material, the product is easy to crack due to impact or vibration that may be generated when the product is used, and element properties may be degraded. Furthermore, in PTL 4, the adhesive force and the retention force are insufficient for use as the sealing material, and the demand level of a moisture resistance property, a moisture-proof property and the like is not satisfied.

For the purpose of solving the above-described problems, PTL 5 discloses an adherent sealing composition used for sealing an organic EL element, which contains a hydrogenated cyclic olefin-based polymer and a polyisobutylene-based resin having a weight-average molecular weight of 500,000 or more, and an adherent film using the composition.

### Citation List

### Patent Literature

PTL 1: Japanese Patent Laid-Open No. 5-182759
PTL 2: Japanese Patent Laid-Open No. 10-74583
PTL 3: Japanese Patent Laid-Open No. 10-233283
PTL 4: Japanese Patent Laid-Open No. 5-101884
PTL 5: Japanese Translation of PCT International Application Publication No. JP-T- 2009-524705

### Summary of Invention

### Technical Problem

However, the adherent film using the adherent sealing composition described in PTL 5 does not have a sufficient suppressing effect on intrusion of moisture (water vapor) or the like for sealing an organic EL element or the like, and moreover, has poor balance between the adhesive force and the retention force. Furthermore, the adherent film is susceptible to a high-temperature environment, ultraviolet irradiation and the like, and thus, when the above-described organic EL element and device are exposed to a high-temperature environment or ultraviolet irradiation due to driving for a long time and a driving environment, a resin component in a layer consisting of the above-described adherent sealing composition of the adherent film may be degraded. As a result, the adherent film described in PTL 5 causes degradation of performance such as adhesion force, a suppressing effect on moisture intrusion, and accordingly, has a problem of causing degradation of an organic EL element.

In addition, the pressure-sensitive adhesive sheet for sealing an organic EL element or the like is required to have a property such as transparency.

It is an object of the present invention to provide a pressure-sensitive adhesive composition capable of forming a pressure-sensitive adhesive layer of a pressure-sensitive adhesive sheet which has excellent adhesive force, excels in a suppressing effect on moisture intrusion, and has good transparency, and a pressure-sensitive adhesive sheet.

### Solution to Problem

The present inventors found that the above-described problems can be solved by a pressure-sensitive adhesive composition containing a styrene-based copolymer having a specific unit and a tackifier having a specific softening point, together with a polyisobutylene-based resin having a specific mass-average molecular weight.

More specifically, the present invention provides the following [1] to [15].
[1] A pressure-sensitive adhesive composition containing: a polyisobutylene-based resin (A) having a mass-average molecular weight of 20,000 or more; one or more styrene-based copolymers (B) selected from the group consisting of a styrene-butadiene-styrene triblock copolymer (SBS), a styrene-block-(ethylene-co-butylene)-block-styrene triblock copolymer (SEBS), a styrene-isobutylene diblock copolymer (SIB), and a styrene-isobutylene-styrene triblock copolymer (SIBS); and a tackifier (C) having a softening point of 135°C or less.
[2] The pressure-sensitive adhesive composition according to the above-described [1], wherein the component (C) contains an aliphatic hydrocarbon resin.
[3] The pressure-sensitive adhesive composition according to the above-described [1] or [2], wherein a softening point of the component (B) is 80 to 200°C.
[4] The pressure-sensitive adhesive composition according to any one of the above-described [1] to [3], wherein a content of the component (B) is 5 to 200 parts by mass with respect to 100 parts by mass of the component (A).
[5] The pressure-sensitive adhesive composition according to any one of the above-described [1] to [4], wherein a content of the component (C) is 5 to 60 parts by mass with respect to 100 parts by mass of the sum of the component (A) and the component (B).
[6] The pressure-sensitive adhesive composition according to any one of the above-described [1] to [5], wherein the component (A) contains an isobutylene-isoprene copolymer (A1) having a structural unit derived from isobutylene (a1) and a structural unit derived from isoprene (a2).
[7] The pressure-sensitive adhesive composition according to the above-described [6], wherein a content of the structural unit (a2) in the isobutylene-isoprene copolymer (A1) is 0.1 to 30 mol% with respect to all structural units of the component (A1).
[8] The pressure-sensitive adhesive composition according to any one of the above-described [1] to [7], wherein a mass-average molecular weight of the component (B) is 10,000 to 400,000.
[9] A pressure-sensitive adhesive sheet having a pressure-sensitive adhesive layer made of the pressure-sensitive adhesive composition according to any one of the above-described [1] to [8].
[10] The pressure-sensitive adhesive sheet according to the above-described [9], wherein the pressure-sensitive adhesive sheet has a structure in which the pressure-sensitive adhesive layer is sandwiched between two release sheets.
[11] The pressure-sensitive adhesive sheet according to the above-described [9], wherein the pressure-sensitive adhesive sheet has a substrate and the pressure-sensitive adhesive layer.
[12] The pressure-sensitive adhesive sheet according to the above-described [11], wherein the substrate is a gas barrier film having a substrate for gas barrier and a gas barrier layer.
[13] The pressure-sensitive adhesive sheet according to any one of the above-described [9] to [12], wherein the pressure-sensitive adhesive sheet has total light transmittance of 90% or more.
[14] The pressure-sensitive adhesive sheet according to any one of the above-described [9] to [13], wherein a water vapor transmission rate of the pressure-sensitive adhesive layer under an environment at 40°C and 90% relative humidity is 10.0 g/m²/day or less.
[15] The pressure-sensitive adhesive sheet according to any one of the above-described [9] to [14], for use of sealing an organic EL element.

### Advantageous Effects of Invention

A pressure-sensitive adhesive sheet having a pressure-sensitive adhesive layer formed from the pressure-sensitive adhesive composition of the present invention has excellent adhesive force, excels in a suppressing effect on moisture intrusion, and has good transparency. Therefore, when the pressure-sensitive adhesive sheet is used for sealing an organic EL element or the like, moisture intrusion into the inside of the element can be suppressed, and property degradation of the organic EL element can be suppressed.

### Brief Description of Drawings

[Fig. 1] Fig. 1 is a diagram showing one example of a structure of a pressure-sensitive adhesive sheet of the present invention.
[Fig. 2] Fig. 2 is a diagram showing one example of an organic device having the pressure-sensitive adhesive sheet of the present invention.
[Fig. 3] Fig. 3 is a diagram showing the relationship between the voltage and the luminance of an organic EL element sealed with the pressure-sensitive adhesive sheet of the present invention or glass.
[Fig. 4] Fig. 4 is (a) a plan view and (b) a front view (cross-sectional view) showing a test laminate manufactured for a moisture intrusion test of a pressure-sensitive adhesive sheet manufactured in the present Examples.

### Description of Embodiments

In the present invention, "mass-average molecular weight (Mw)" is a value in terms of standard polystyrene measured by the gel permeation chromatography (GPC) method, and specifically, a value measured based on a method described in Examples.

In addition, "softening point" is a value measured in conformity with JIS K 2531.

### [Pressure-sensitive adhesive composition]

A pressure-sensitive adhesive composition of the present invention contains a polyisobutylene-based resin (A) having a mass-average molecular weight of 20,000 or more, one or more styrene-based copolymers (B) selected from the group consisting of a styrene-butadiene-styrene triblock copolymer (SBS), a styrene-block-(ethylene-co-butylene)-block-styrene triblock copolymer (SEBS), a styrene-isobutylene diblock copolymer (SIB), and a styrene-isobutylene-styrene triblock copolymer (SIBS), and a tackifier (C) having a softening point of 135°C or less.

The pressure-sensitive adhesive composition of the present invention may contain additives and resins other than the components (A) to (C) as long as not impairing the effects of the present invention. Hereinafter, each component contained in the pressure-sensitive adhesive composition of the present invention will be described in detail.

### <Polyisobutylene-Based Resin (A)>

The polyisobutylene-based resin (A) contained in the pressure-sensitive adhesive composition of the present invention is a polyisobutylene-based resin having a mass-average molecular weight of 20,000 or more.

When the mass-average molecular weight of the component (A) is less than 20,000, the cohesive force of the pressure-sensitive adhesive composition cannot be sufficiently obtained, and the pressure-sensitive adhesive property cannot be sufficiently improved. In addition, when a pressure-sensitive adhesive sheet using the pressure-sensitive adhesive composition is used for sealing, the adhesive force of the pressure-sensitive adhesive sheet is insufficient, and the suppressing effect on moisture intrusion of the pressure-sensitive adhesive sheet is also insufficient. Furthermore, an adherend may be contaminated.

It is to be noted that, basically, when the mass-average molecular weight of the component (A) is higher, the adhesive force of the pressure-sensitive adhesive sheet using the obtained pressure-sensitive adhesive composition is more improved, and the suppressing effect on moisture intrusion when using the pressure-sensitive adhesive sheet for sealing also tends to be improved.

The mass-average molecular weight of the component (A) is 20,000 or more, and from the above-described viewpoint and the viewpoint of the wettability against an adherend and the solubility against a solvent, it is preferably 30,000 to 1,000,000, more preferably 50,000 to 800,000, further preferably 70,000 to 600,000, and still further preferably 140,000 to 450,000.

In the present invention, the structure of the polyisobutylene-based resin (A) is a resin having a polyisobutylene skeleton at the main chain or the side chain, and specifically, a resin having the following structural unit (a).

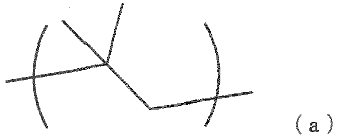

Examples of the polyisobutylene-based resin include polyisobutylene that is a homopolymer of isobutylene, a copolymer of isobutylene and isoprene, a copolymer of isobutylene and n-butene, a copolymer of isobutylene and butadiene, and halogenated butyl rubbers obtained by bromizing or chlorinating these copolymers.

These polyisobutylene-based resins may be used singly or in combination of two or more kinds thereof.

It is to be noted that, when the above-described polyisobutylene-based resin is a copolymer, the structural unit derived from isobutylene shall be most contained among all structural units constituting the polyisobutylene-based resin.

The content of the structural unit derived from isobutylene is preferably 60 mol% or more, more preferably 70 mol% or more, more preferably 80 mol% or more, further preferably 90 mol% or more, and still further preferably 95 mol% or more, with respect to the all structural units of the component (A).

In addition, when the above-described polyisobutylene-based resin contained as the component (A) is a copolymer, the copolymer is one not containing a structural unit derived from styrene, and is distinguished from the component (B).

Examples of a synthesis method of the polyisobutylene-based resin include a method of polymerizing a monomer component such as isobutylene in the presence of a Lewis acid catalyst such as aluminum chloride and boron trifluoride.

Moreover, as the component (A), commercial products such as Vistanex (manufactured by Exxon Chemical Co.), Hycar (manufactured by Goodrich), and Oppanol (manufactured by BASF) can also be used.

From the viewpoint of improving the adhesive force and making the suppressing effect on moisture intrusion good, the content of the component (A) with respect to the total amount of the pressure-sensitive adhesive composition of the present invention is preferably 20 to 90 mass%, more preferably 25 to 85 mass%, further preferably 30 to 80 mass%, and still further preferably 35 to 75 mass%.

From the viewpoint of keeping the value of the water vapor transmission rate of the pressure-sensitive adhesive layer formed from the obtained pressure-sensitive adhesive composition low and obtaining the pressure-sensitive adhesive sheet that excels in the suppressing effect on moisture intrusion, the component (A) preferably contains an isobutylene-isoprene copolymer (A1) having a structural unit derived from isobutylene (a1) and a structural unit derived from isoprene (a2).

From the above-described viewpoint, the content of the isobutylene-isoprene copolymer (A1) in the component (A) is preferably 50 to 100 mass%, more preferably 65 to 100 mass%, further preferably 80 to 100 mass%, and still further preferably 90 to 100 mass%.

From the viewpoint of keeping the value of the water vapor transmission rate of the pressure-sensitive adhesive layer formed from the obtained pressure-sensitive adhesive composition low and obtaining the pressure-sensitive adhesive sheet that excels in the suppressing effect on moisture intrusion, the content of the structural unit derived from isoprene (a2) in the isobutylene-isoprene copolymer (A1) is preferably 0.1 to 30.0 mol%, more preferably 0.5 to 20.0 mol%, further preferably 0.8 to 15.0 mol%, and still further preferably 1.3 to 10.0 mol%, with respect to all structural units of the component (A1).

In addition, the content of the structural unit derived from isobutylene (a1) is preferably 70.0 to 99.9 mol%, more preferably 80.0 to 99.5, further preferably 85.0 to 99.2, and still further preferably 90.0 to 98.7, with respect to the all structural units of the component (A1).

The mass-average molecular weight (Mw) of the component (A1) is 20,000 or more, and is preferably 30,000 to 1,000,000, more preferably 50,000 to 800,000, more preferably 70,000 to 600,000, further preferably 140,000 to 450,000, and still further preferably 180,000 to 350,000.

In addition, from the viewpoint of improving the adhesive force, durability, weatherability, and wettability of the pressure-sensitive adhesive sheet using the obtained pressure-sensitive adhesive composition, the combination of a polyisobutylene-based resin having a high mass-average molecular weight with a polyisobutylene-based resin having a low mass-average molecular weight is preferably used as the component (A), and the combination preferably contains a polyisobutylene-based resin having a mass-average molecular weight of 270,000 to 600,000 (α) (hereinafter, also referred to as "resin (α)") and a polyisobutylene-based resin having a mass-average molecular weight of 50,000 to 250,000 (β) (hereinafter, also referred to as "resin (β)").

The containing of the resin having a high mass-average molecular weight (α) contributes to an improvement in the durability, weatherability, and adhesive force of the pressure-sensitive adhesive layer formed from the obtained pressure-sensitive adhesive composition, and contributes to an improvement in the suppressing effect on moisture intrusion when using the pressure-sensitive adhesive sheet using the pressure-sensitive adhesive composition for sealing.

In addition, the containing of the resin having a low mass-average molecular weight (β), which is well compatible with the resin (α), can moderately plasticize the resin (α), thereby to increase the wettability against the adherend of the pressure-sensitive adhesive layer formed from the pressure-sensitive adhesive composition and to improve the adhesive properties, flexibility and the like.

The mass-average molecular weight (Mw) of the resin (α) is preferably 270,000 to 600,000, more preferably 290,000 to 480,000, further preferably 310,000 to 450,000, and still further preferably 320,000 to 400,000.

When Mw of the resin (α) is 270,000 or more, the cohesive force of the obtained pressure-sensitive adhesive composition can be sufficiently improved, and the adhesive force of the pressure-sensitive adhesive sheet using the pressure-sensitive adhesive composition and the suppressing effect on moisture intrusion can be improved. Furthermore, concern about contamination of the adherend can be resolved.

In contrast, when Mw of the resin (α) is 600,000 or less, an adverse effect of lowering flexibility and fluidity due to too high cohesive force of the obtained pressure-sensitive adhesive composition can be avoided, and the wettability with the adherend of the pressure-sensitive adhesive layer formed from the pressure-sensitive adhesive composition becomes good. Furthermore, the solubility in a solvent when making a solution from the pressure-sensitive adhesive composition becomes good.

The mass-average molecular weight (Mw) of the resin (β) is preferably 50,000 to 250,000, more preferably 80,000 to 230,000, further preferably 140,000 to 220,000, and still further preferably 180,000 to 210,000.

When Mw of the resin (β) is 50,000 or more, in the pressure-sensitive adhesive layer formed from the obtained pressure-sensitive adhesive composition, an adverse effect of contamination of the adherend due to separation of the resin (β) as a low-molecular component and precipitation of the resin (β) on the surface of the pressure-sensitive adhesive layer can be avoided. Furthermore, effects on physical properties, such as an increase in the amount of outgas generated, which is generated under high temperature, can also be avoided.

In contrast, when Mw of the resin (β) is 250,000 or less, the resin (A1) can be sufficiently plasticized, and the wettability with the adherend of the pressure-sensitive adhesive layer formed from the obtained pressure-sensitive adhesive composition becomes good.

It is to be noted that each of the above-described resins (α) and (β) may be used singly or in combination of two or more kinds thereof.

The content of the resin (β) with respect to 100 parts by mass of the resin (α) is preferably 5 to 55 parts by mass, more preferably 6 to 40 parts by mass, further preferably 7 to 30 parts by mass, and still further preferably 8 to 20 parts by mass.

When the content of the resin (β) is 5 parts by mass or more, the resin (α) can be sufficiently plasticized, and the wettability with the adherend of the pressure-sensitive adhesive layer formed from the obtained pressure-sensitive adhesive composition becomes good, and furthermore, the adhesive force can be improved.

In contrast, when the content of the resin (β) is 55 parts by mass or less, the cohesive force of the obtained pressure-sensitive adhesive composition can be sufficiently improved, and therefore, excellent adhesive force and durability can be imparted to the pressure-sensitive adhesive sheet using the pressure-sensitive adhesive composition.

### <Styrene-Based Copolymer (B)>

The pressure-sensitive adhesive composition of the present invention contains one or more styrene-based copolymers (B) selected from the group consisting of a styrene-butadiene-styrene triblock copolymer (SBS), a styrene-block-(ethylene-co-butylene)-block-styrene triblock copolymer (SEBS), a styrene-isobutylene diblock copolymer (SIB), and a styrene-isobutylene-styrene triblock copolymer (SIBS).

By containing one or more styrene-based copolymers selected from the above-described group in the pressure-sensitive adhesive composition, as the component (B), the suppressing effect on moisture intrusion of the pressure-sensitive adhesive sheet using the obtained pressure-sensitive adhesive composition becomes good, and the adhesive force of the pressure-sensitive adhesive sheet can be improved.

From the viewpoint of improving the adhesive force of the pressure-sensitive adhesive sheet using the obtained pressure-sensitive adhesive composition, among the components (B), one or more selected from SBS and SEBS are preferable. Furthermore, from the viewpoint of improving the suppressing effect on moisture intrusion of the pressure-sensitive adhesive sheet, one or more selected from SIB and SIBS are preferable.

From the viewpoint of making the suppressing effect on moisture intrusion of the pressure-sensitive adhesive sheet using the obtained pressure-sensitive adhesive composition good and improving the adhesive force of the pressure-sensitive adhesive sheet, the mass-average molecular weight (Mw) of the component (B) is preferably 10,000 to 400,000, more preferably 20,000 to 300,000, further preferably 25,000 to 200,000, and still further preferably 30,000 to 90,000.

When Mw of the component (B) is 10,000 or more, the adhesive force of the pressure-sensitive adhesive sheet using the obtained pressure-sensitive adhesive composition can be improved. In contrast, when Mw of the component (B) is 400,000 or less, the value of the water vapor transmission rate of the pressure-sensitive adhesive layer formed from the obtained pressure-sensitive adhesive composition can be reduced and the suppressing effect on moisture intrusion of the pressure-sensitive adhesive sheet can be improved, while the adhesive force of the pressure-sensitive adhesive sheet using the obtained pressure-sensitive adhesive composition is kept good.

From the viewpoint of improving the suppressing effect on moisture intrusion of the pressure-sensitive adhesive sheet when the pressure-sensitive adhesive sheet using the pressure-sensitive adhesive composition is used for sealing an organic EL element or the like and the viewpoint of improving the adhesive force of the pressure-sensitive adhesive sheet, the softening point of the component (B) is preferably 80 to 200°C, more preferably 90 to 160°C, further preferably 100 to 140°C, and still further preferably 105 to 135°C.

The ratio of styrene contained in the styrene-based copolymer of the component (B) is preferably 5 to 50 mass%, more preferably 10 to 40 mass%, and further preferably 15 to 35 mass%.

The content of the component (B) is preferably 5 to 200 parts by mass, more preferably 6 to 140 parts by mass, more preferably 7 to 120 parts by mass, further preferably 8 to 95 parts by mass, and still further preferably 9 to 88 parts by mass, with respect to 100 parts by mass of the component (A).

When the content of the component (B) is 5 parts by mass or more, moisture intrusion is effectively suppressed and property degradation of the organic EL element can be suppressed, in a case where the pressure-sensitive adhesive sheet using the pressure-sensitive adhesive composition is used for sealing an organic EL element or the like. Furthermore, the adhesive force of the pressure-sensitive adhesive sheet can also be improved.

In contrast, when the content of the component (B) is 200 parts by mass or less, the adhesive force of the pressure-sensitive adhesive sheet using the obtained pressure-sensitive adhesive composition can be sufficiently improved, and the value of the water vapor transmission rate of the pressure-sensitive adhesive layer formed from the pressure-sensitive adhesive composition is reduced, and the suppressing effect on moisture intrusion of the pressure-sensitive adhesive sheet becomes good.

The ratio of the content of the component (A) to the content of the component (B) [(A)/(B)] is preferably 40/60 to 95/5, more preferably 45/55 to 92/8, more preferably 50/50 to 90/10, further preferably 55/45 to 88/12, further preferably 60/40 to 85/15, and still further preferably 65/35 to 82/15.

When the ratio is within the above-described range, the value of the water vapor transmission rate of the pressure-sensitive adhesive layer formed from the pressure-sensitive adhesive composition can be reduced and the suppressing effect on moisture intrusion of the pressure-sensitive adhesive sheet becomes good, while the adhesive force of the pressure-sensitive adhesive sheet using the obtained pressure-sensitive adhesive composition is improved.

From the viewpoint of improving the compatibility and the suppressing effect on moisture intrusion, the content of the component (B) with respect to the total amount of the pressure-sensitive adhesive composition of the present invention is preferably 2 to 60 mass%, more preferably 4 to 55 mass%, further preferably 6 to 50 mass%, and still further preferably 8 to 47 mass%.

### <Tackifier (C)>

The pressure-sensitive adhesive composition of the present invention contains a tackifier (C) having a softening point of 135°C or less.

In the present invention, the tackifier indicates a compound having a molecular weight in the oligomer region, which can be mixed with the above-described components (A) and (B) and other resin components and has a function to improve the adhesive performance of these resin components.

The number average molecular weight of the tackifier is usually 100 to 18,000, and preferably 100 to 10,000.

In the present invention, the softening point of the tackifier (C) is 135°C or less.

The softening point of the tackifier (C) more than 135°C is not preferable because the pressure-sensitive adhesive property of the pressure-sensitive adhesive composition containing the components (A) and (B) is significantly decreased. In addition, zipping may occur when peeling off the pressure-sensitive adhesive sheet using the pressure-sensitive adhesive composition.

Although the softening point of the tackifier (C) is 135°C or less, it is preferably 132°C or less, more preferably 128°C or less, more preferably 120°C or less, further preferably 110°C or less, and further preferably 105°C or less from the above-described viewpoint.

In contrast, from the viewpoint of improving the cohesive force of the obtained pressure-sensitive adhesive composition and obtaining the pressure-sensitive adhesive composition that exhibits an excellent pressure-sensitive adhesive property, the softening point of the tackifier (C) is preferably 60°C or more, more preferably 70°C or more, further preferably 80°C or more, and still further preferably 90°C or more.

In the present invention, two or more kinds of tackifiers (C) having different softening points may be combined. When a plurality of tackifiers is used, the weighted average of the softening points of these tackifiers only has to be within the above-described range. Therefore, in the present invention, as long as the weighted average of the softening points of the plurality of tackifiers is 135°C or less (within the above-described range), a tackifier having a softening point more than 135°C may be contained in the pressure-sensitive adhesive composition.

The content of the tackifier having a softening point more than 135°C is preferably 10 mass% or less, more preferably 4 mass% or less, further preferably 1 mass% or less, and still further preferably 0.01 mass% or less, with respect to the total amount of the tackifiers (C) contained in the pressure-sensitive adhesive composition.

Examples of the tackifier (C) include those having a softening point of 135°C or less, among aliphatic hydrocarbon resins, resins derived from organism, such as rosin-based resins such as a rosin resin, a rosin phenol resin, and a rosin ester resin; hydrogenated rosin-based resins obtained by hydrogenating these rosin-based resins; terpene-based resins such as a terpene-based resin, a terpene phenol-based resin, and an aromatic modified terpene-based resin; and hydrogenated terpene-based resins obtained by hydrogenating these terpene-based resins; and resins derived from petroleum, such as C5-based petroleum resins and hydrogenated petroleum resins of the C5-based petroleum resins; and C9-based petroleum resins obtained by copolymerizing C9 fractions and hydrogenated petroleum resins of the C9-based petroleum resins; and the like.

The above-described tackifiers may be used singly or in combination of two or more kinds thereof.

Here, the above-described "C5 fractions" indicate unsaturated hydrocarbons having 5 carbon atoms, such as pentene, isoprene, piperine, and 1,3-pentadiene, generated by thermal decomposition of petroleum naphtha, and the "C5-based petroleum resins" indicate resins obtained by copolymerizing the C5 fractions and containing the C5 fractions as the main component (containing at least 20 mass% or more).

In addition, the above-described "C9 fractions" indicate unsaturated hydrocarbons having 9 carbon atoms, such as indene, vinyl toluene, and α or β-methylstyrene, generated by thermal decomposition of petroleum naphtha, and the "C9-based petroleum resins" indicate resins obtained by copolymerizing the C9 fractions and containing the C9 fractions as the main component (containing at least 20 mass% or more).

It is to be noted that the above-described "hydrogenated resins" include not only perhydrogenated resins that are fully hydrogenated but also partially hydrogenated resins that are partially hydrogenated.

Among these tackifiers, aliphatic hydrocarbon resins are preferable from the viewpoint of obtaining the pressure-sensitive adhesive sheet which has a small value of the water vapor transmission rate of the pressure-sensitive adhesive layer formed from the obtained pressure-sensitive adhesive composition and excels in the suppressing effect on moisture intrusion.

It is to be noted that, in the present invention, the "aliphatic hydrocarbon resins" are resins derived from petroleum and not having an aromatic ring and an alicyclic structure. In other words, the "aliphatic hydrocarbon resins" are clearly distinguished from "aromatic hydrocarbon resins" having an aromatic ring and "alicyclic hydrocarbon resins" such as a dicyclopentadiene-based resin.

The aliphatic hydrocarbon resins are compounds in the oligomer region, having a number average molecular weight of 100 to 18,000 (preferably 100 to 10,000), and are preferably polymers of one or more aliphatic hydrocarbons selected from olefins and dienes having 4 or 5 carbon atoms.

Examples of the above-described olefins include 1-butene, isobutylene, and 1-pentene.

In addition, examples of the above-described dienes include butadiene, 1,3-pentadiene, and isoprene.

In addition, the aliphatic hydrocarbon resins may be fully hydrogenated resins that are fully hydrogenated and partially hydrogenated resins that are partially hydrogenated.

The above-described aliphatic hydrocarbon resins may be used singly or in combination of two or more kinds thereof.

Among the above-described aliphatic hydrocarbon resins, from the viewpoint of obtaining the pressure-sensitive adhesive sheet which has a small value of the water vapor transmission rate of the pressure-sensitive adhesive layer formed from the obtained pressure-sensitive adhesive composition and excels in the suppressing effect on moisture intrusion, aliphatic hydrocarbon resins manufactured mainly from the C5 fractions (containing at least 20 mass% or more) are preferable, aliphatic hydrocarbon resins manufactured mainly from the dienes of the C5 fractions are more preferable, and aliphatic hydrocarbon resins manufactured mainly from 1,3-pentadiene are further preferable.

The content of the aliphatic hydrocarbon resins is preferably 60 to 100 mass%, more preferably 70 to 100 mass%, further preferably 80 to 100 mass%, and still further preferably 90 to 100 mass%, with respect to the total amount of the tackifiers (C) contained in the pressure-sensitive adhesive composition of the present invention.

It is to be noted that, in the pressure-sensitive adhesive composition of the present invention, from the viewpoint of obtaining the pressure-sensitive adhesive sheet which has a small value of the water vapor transmission rate of the pressure-sensitive adhesive layer formed from the obtained pressure-sensitive adhesive composition and excels in the suppressing effect on moisture intrusion, aromatic hydrocarbon resins or alicyclic hydrocarbon resins are not preferably contained.

From the above-described viewpoint, the content of the aromatic hydrocarbon resins and the alicyclic hydrocarbon resins is preferably 10 mass% or less, more preferably 5 mass% or less, further preferably 1 mass% or less, and still further preferably 0.01 mass% or less, with respect to the total amount of the tackifiers (C) contained in the pressure-sensitive adhesive composition of the present invention.

The content of the component (C) is preferably 5 to 60 parts by mass, more preferably 8 to 50 parts by mass, further preferably 10 to 45 parts by mass, and still further preferably 15 to 42 parts by mass, with respect to 100 parts by mass of the sum of the component (A) and the component (B).

When the content of the component (C) is 5 parts by mass or more, in the pressure-sensitive adhesive layer formed from the obtained pressure-sensitive adhesive composition, the wettability with the adherend is sufficiently obtained and the adhesive force can be improved, and furthermore, the pressure-sensitive adhesive sheet which has a small value of the water vapor transmission rate of the pressure-sensitive adhesive layer and excels in the suppressing effect on moisture intrusion can be obtained.

In contrast, when the content of the component (C) is 60 parts by mass or less, in the pressure-sensitive adhesive layer formed from the obtained pressure-sensitive adhesive composition, excellent adhesive force can be exhibited regardless of the adherend, and the occurrence of zipping can be suppressed. Furthermore, the pressure-sensitive adhesive sheet which has a small value of the water vapor transmission rate of the pressure-sensitive adhesive layer and excels in the suppressing effect on moisture intrusion can be obtained.

From the above-described viewpoint, the content of the component (C) with respect to the total amount of the pressure-sensitive adhesive composition of the present invention is preferably 3 to 50 mass%, more preferably 5 to 40 mass%, further preferably 8 to 35 mass%, and still further preferably 12 to 30 mass%.

### <Other Additives>

The pressure-sensitive adhesive composition of the present invention may further contain other additives as long as not impairing the effects of the present invention.

Examples of the other additives include a light stabilizing agent, an antioxidizing agent, an ultraviolet absorbing agent, a resin stabilizer, a filler, a pigment, an extender, and a softener. These additives may be used singly or in combination of two or more kinds thereof.

Each content of these other components is preferably 0.01 to 5 parts by mass, and more preferably 0.01 to 2 parts by mass, with respect to 100 parts by mass of the component (A).

Examples of the light stabilizing agent include hindered amine-based, benzophenone-based, and benzotriazole-based light stabilizing agents.

Examples of the antioxidizing agent include a phosphate-based compound.

Examples of the ultraviolet absorbing agent include a benzotriazole-based compound, an oxazolic acid amide compound, and a benzophenone-based compound.

Examples of the resin stabilizer include an imidazole-based resin stabilizer, a dithiocarbamate-based resin stabilizer, a phosphorus-based resin stabilizer, and a sulfur ester-based resin stabilizer.

### <Resin Components other than components (A) to (C)>

It is to be noted that the pressure-sensitive adhesive composition of the present invention may contain resin components other than the above-described components (A) to (C) as long as not impairing the effects of the present invention, but preferably does not substantially contain them.

The content of the resin components other than the components (A) to (C) is preferably less than 50 mass%, more preferably 20 mass% or less, further preferably 5 mass% or less, and still further preferably 1 mass% or less, with respect to the total amount of the pressure-sensitive adhesive composition.

It is to be noted that examples of the resins other than the components (A) to (C) include styrene-based copolymers that do not correspond to the component (B).

Examples of the styrene-based copolymers that do not correspond to the component (B) include a styrene-butadiene diblock copolymer, a styrene-isoprene diblock copolymer, a styrene-isoprene-styrene triblock copolymer, a styrene-block-(butadiene-co-isoprene)-block diblock copolymer, a styrene-block-(butadiene-co-isoprene)-block-styrene triblock copolymer, a styrene-block-(ethylene-co-butylene)-block diblock copolymer (SEB), the above-described styrene copolymers that are carboxyl-modified, and copolymers of styrene with an aromatic vinyl compound such as α-methylstyrene.

### [Pressure-sensitive adhesive sheet]

The pressure-sensitive adhesive sheet of the present invention is not particularly limited as long as it has the pressure-sensitive adhesive layer made of the pressure-sensitive adhesive composition of the present invention containing the above-described components.

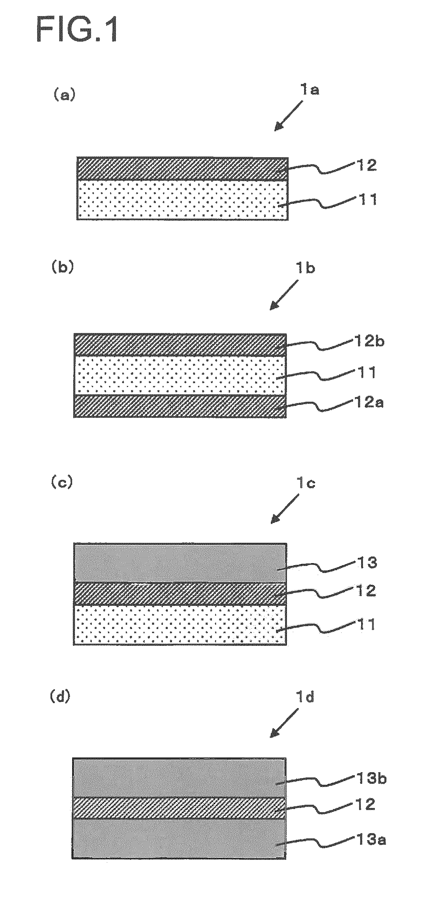

Examples of the structure of the pressure-sensitive adhesive sheet of the present invention include a pressure-sensitive adhesive sheet 1a having an pressure-sensitive adhesive layer 12 on a substrate 11, as in Fig. 1(a).

In addition, it may be a pressure-sensitive adhesive sheet 1b in which pressure-sensitive adhesive layers 12a, 12b are formed on both surfaces of the substrate 11, as in Fig. 1(b), or a pressure-sensitive adhesive sheet 1c in which a peelable release sheet 13 is further formed on the pressure-sensitive adhesive layer 12 formed on the substrate 11, as in Fig. 1(c). In addition, the pressure-sensitive adhesive sheet 1b may further have release sheets on the pressure-sensitive adhesive layers 12a, 12b.

Furthermore, it may be a pressure-sensitive adhesive sheet 1d in which the pressure-sensitive adhesive layer 12 is sandwiched between two release sheets 13a, 13b without using a substrate, as in Fig. 1(d). It is to be noted that, in the pressure-sensitive adhesive sheet 1d, the release sheets 13a, 13b may be the same kind or different kinds, and it is preferable to arbitrarily select the release sheets to be used such that the peel force between the release sheet 13a and the release sheet 13b is different.

It also may be a rolled pressure-sensitive adhesive sheet having a structure in which a pressure-sensitive adhesive layer is provided on one surface of a release sheet subjected to peeling treatment.

It is to be noted that the shape of the pressure-sensitive adhesive sheet of the present invention is not particularly limited, and examples thereof include a sheet shape and a roll shape. For example, it is preferably a sheet shape when being used as a member for an electronic device.

The pressure-sensitive adhesive sheet of the present invention exhibits excellent adhesive force even when the thickness of the pressure-sensitive adhesive layer itself is thin, and furthermore, has high adhesive force regardless of the kind of the adherend.

Specifically, the adhesive force of the pressure-sensitive adhesive sheet having the pressure-sensitive adhesive layer having a thickness of 20 µm after being attached to the adherend and left for 24 hours under the environment at 23°C and 50% RH (relative humidity) is preferably 9.0 N/25 mm or more, more preferably 10.0 N/25 mm or more, and further preferably 12.0 N/25 mm or more when the adherend is glass, and is preferably 9.0 N/25 mm or more, more preferably 10.0 N/25 mm or more, and further preferably 12.0 N/25 mm or more when the adherend is stainless.

The pressure-sensitive adhesive sheet has sufficient adhesive force when the adhesive force is in the above-described range, and even when being exposed to heat generated during driving of an organic EL element and high temperature during the driving, dissociation of an interface due to stress at the interface of a structure in the organic EL element, which is generated by the difference of thermal expansion coefficients of the respective constituents, can be suppressed.

In addition, when the pressure-sensitive adhesive sheet of the present invention is in the form of a pressure-sensitive adhesive sheet without a substrate, as the pressure-sensitive adhesive sheet 1d in Fig. 1(d), it is preferable to adjust the adhesive force when the pressure-sensitive adhesive sheet is lined with polyethylene terephthalate having a thickness of 50 µm to be in the above-described range.

It is to be noted that the above-described value of the adhesive force of the pressure-sensitive adhesive sheet indicates a value measured by a method described in Examples.

The pressure-sensitive adhesive layer in the pressure-sensitive adhesive sheet of the present invention has excellent transparency.

From the viewpoint of being applied to the intended use of sealing an organic EL element or the like, the pressure-sensitive adhesive sheet of the present invention preferably has total light transmittance of 90% or more.

In addition, the haze of the pressure-sensitive adhesive sheet of the present invention is preferably 1.20 or less, more preferably 1.00 or less, and further preferably 0.90 or less.

In addition, the above-described value of the total light transmittance of the pressure-sensitive adhesive sheet is a value measured in conformity with JIS K 7361-1, the value of the haze is a value measured in conformity with JIS K 7136, and specifically, both indicate values measured by a method described in Examples.

Hereinafter, each constituent of the pressure-sensitive adhesive sheet of the present invention will be described.

### <Pressure-sensitive adhesive layer>

The thickness of the pressure-sensitive adhesive layer of the pressure-sensitive adhesive sheet is arbitrarily selected depending on the intended use and the like, and is preferably 0.5 to 100 µm, more preferably 1 to 60 µm, and further preferably 3 to 40 µm.

When the thickness of the pressure-sensitive adhesive layer is 0.5 µm or more, good adhesive force can be obtained with respect to the adherend.

In contrast, when the thickness of the pressure-sensitive adhesive layer is 100 µm or less, the pressure-sensitive adhesive sheet can become advantageous in terms of productivity and easy to be handled.

The water vapor transmission rate of the pressure-sensitive adhesive layer having a thickness of 60 µm in the pressure-sensitive adhesive sheet of the present invention under the environment at 40°C and 90% RH (relative humidity) is preferably 10.0 g/m²/day or less, more preferably 7.0 g/m²/day or less, further preferably 5.0 g/m²/day or less, and still further preferably 4.0 g/m²/day or less.

When the water vapor transmission rate of the pressure-sensitive adhesive layer is 10 g/m²/day or less, the pressure-sensitive adhesive sheet of the present invention excels in the suppressing effect on moisture intrusion, and even when the pressure-sensitive adhesive sheet is used for sealing an organic EL element or the like, moisture intrusion into the inside of the element can be suppressed, and property degradation of the organic EL element can be suppressed.

It is to be noted that the value of the water vapor transmission rate of the pressure-sensitive adhesive layer indicates a value measured by a method described in Examples.

The pressure-sensitive adhesive layer in the pressure-sensitive adhesive sheet of the present invention has excellent transparency.

The total light transmittance of the pressure-sensitive adhesive layer is preferably 90% or more. In addition, the visible light transmittance at a wavelength of 550 nm of the pressure-sensitive adhesive layer is preferably 90% or more.

When the total light transmittance or the visible light transmittance of the pressure-sensitive adhesive layer is 90% or more, the pressure-sensitive adhesive sheet of the present invention can be suitably used for sealing an organic EL element or the like.

In addition, the haze of the pressure-sensitive adhesive layer is preferably 1.20 or less, more preferably 1.00 or less, and further preferably 0.90 or less.

It is to be noted that the above-described value of the total light transmittance is a value measured in conformity with JIS K 7361-1, the value of the haze is a value measured in conformity with JIS K 7136, and specifically, both indicate values measured by a method described in Examples.

In addition, the above-described value of the visible light transmittance indicates a value measured by a method described in Examples.

The pressure-sensitive adhesive layer in the pressure-sensitive adhesive sheet of the present invention is small in the amount of outgas generated, which can be generated from the pressure-sensitive adhesive layer. In the present invention, the amount of outgas generated is evaluated by comparison with a value in terms of n-decane.

The amount of outgas generated when heating the pressure-sensitive adhesive layer having a thickness of 20 µm at 120°C for 30 minutes, in terms of n-decane, is preferably less than 1.0 µg/cm², more preferably 0.5 µg/cm² or less, and further preferably 0.1 µg/cm² or less.

When the amount of outgas generated is less than 1.0 µg/cm², the pressure-sensitive adhesive layer does not corrode the adherend. Thus, for example, even when the pressure-sensitive adhesive sheet of the present invention is applied to the use of being attached to a precision apparatus, the possibility of malfunction of a precision electronic member is significantly decreased.

It is to be noted that the value of the amount of outgas generated of the pressure-sensitive adhesive layer indicates a value measured by a method described in Examples.

### <Substrate>

The substrate is not particularly limited as long as it is a sheet shape, and is arbitrarily selected depending on the intended use of the pressure-sensitive adhesive sheet of the present invention. Examples thereof include various paper such as high-quality paper, art paper, coated paper, glassine paper, and laminated paper obtained by laminating a thermoplastic resin such as polyethylene on these paper substrates, various synthetic paper, metal foil such as aluminum foil, copper foil, and iron foil, a porous material such as non-woven fabric, a plastic film or sheet made of polyolefin resins such as a polyethylene resin and a polypropylene resin, polyester resins such as a polybutylene terephthalate resin and a polyethylene terephthalate resin, an acetate resin, an ABS resin, a polystyrene resin, a vinyl chloride resin and the like, and a plastic film or sheet made of a mixture or a laminate of these resins. A sheet-shaped substrate such as a plastic film or sheet may be unstretched, or stretched in a uniaxial direction or in a biaxial direction, such as longitudinal or transverse.

Although it does not matter whether the substrate to be used is colored, when the substrate to be used is used as a sealing member, it is preferably one through which ultraviolet rays pass sufficiently, and furthermore, is more preferably colorless and transparent in the visible light region.

In addition, in the pressure-sensitive adhesive sheet of the present invention, a gas barrier film having a substrate for gas barrier and a gas barrier layer may be used as a substrate in place of the substrate made of the above-described materials. The details about the gas barrier film are as described below.

The thickness of the substrate is not particularly limited, but from the viewpoint of ease of handling, it is preferably 10 to 250 µm, more preferably 15 to 200 µm, and further preferably 20 to 150 µm.

It is to be noted that the substrate may further contain an ultraviolet absorbing agent, a light stabilizing agent, an antioxidizing agent, an antistatic agent, a slip agent, an antiblocking agent, a coloring agent and the like.

When the substrate is a plastic-based material, from the viewpoint of improving an adhesion property of the substrate with the pressure-sensitive adhesive layer, the surface of the substrate is preferably subjected to surface treatment such as an oxidation method and a roughening method, as necessary.

The oxidation method is not particularly limited, and examples thereof include a corona discharge treatment method, a plasma treatment method, chromium acid oxidation (wet type), flame treatment, hot-air treatment, and ozone/ultraviolet irradiation treatment. Moreover, the roughening method is not particularly limited, and examples thereof include a sandblast method and a solvent treatment method.

The surface treatment is arbitrarily selected depending on the kind of the substrate, and from the viewpoint of an improving effect of an adhesion property with the pressure-sensitive adhesive layer and handleability, a corona discharge treatment method is preferable. Furthermore, primer treatment can also be performed.

A stopping material layer may be optionally provided between the substrate and the pressure-sensitive adhesive layer depending on the kind of the substrate. The stopping material layer is provided so as to further improve the adhesion property between the substrate and the pressure-sensitive adhesive layer or to impart a stiffness property when the substrate is paper and is too flexible, in addition to the prevention of penetration of the pressure-sensitive adhesive composition or the solution of the pressure-sensitive adhesive composition into the substrate.

Such a stopping material layer is not particularly limited, and examples thereof include a layer made of a styrene-butadiene copolymer, an acrylic-based resin, a polyester-based resin, a polyurethane-based resin, a polystyrene-based resin or the like as a main component (containing at least 20 mass% or more), to which a filler, such as clay, silica, calcium carbonate, titanium oxide, and zinc oxide, is added as needed.

The thickness of the stopping material layer is not particularly limited, and is usually 0.1 to 30 µm.

### <Gas Barrier Film>

As the substrate of the pressure-sensitive adhesive sheet of the present invention, it is preferable to use a gas barrier film having a substrate for gas barrier and a gas barrier layer. The gas barrier film only has to have the gas barrier layer on at least one surface side of the substrate for a gas barrier film. It is to be noted that the gas barrier layer may be a single layer or a multiple layer.

### (Substrate for Gas barrier Film)

The substrate for a gas barrier film is not particularly limited, and examples thereof include a sheet and the like made of polyolefins such as polyethylene and polypropylene, polyesters such as polyethylene terephthalate and polybutylene terephthalate, polyamides such as polyimide, polyamideimide, a wholly aromatic polyamide, Nylon 6, Nylon 66, and a nylon copolymer, cycloolefin-based polymers such as a norbornene-based polymer, a monocyclic cyclic olefin-based polymer, a cyclic conjugated diene-based polymer, a vinyl-alicyclic hydrocarbon polymer, and hydrogenated products thereof, and resins such as polyphenylene ether, polyether ketone, polyether ether ketone, polycarbonate, polysulfone, polyether sulfone, polyphenylene sulfide, and polyarylate.

Among them, from the viewpoint of excellent transparency and general versatility, polyesters, polyamides, or cycloolefin-based polymers are preferable, and polyesters or cycloolefin-based polymers are more preferable.

The thickness of the substrate for a gas barrier film is not particularly limited, but from the viewpoint of ease of handling, it is preferably 2 to 200 µm, more preferably 10 to 150 µm, and further preferably 20 to 100 µm.

### (Gas Barrier Layer)

A material for forming the gas barrier layer is not particularly limited as long as it prevents permeation of oxygen and water vapor, and examples thereof include metals such as aluminum, magnesium, zinc, and tin, silicon compounds such as silicon nitride, silicon oxide, silicon oxynitride, a polysilazane compound, a polycarbosilane compound, a polysilane compound, a polyorganosiloxane compound, and a tetraorganosilane compound, aluminum compounds such as aluminum oxide and aluminum oxynitride, inorganic oxides such as magnesium oxide, zinc oxide, indium oxide, and tin oxide, and resins such as a polyvinyl alcohol, an ethylene-vinyl alcohol copolymer, polyvinyl chloride, polyvinylidene chloride, and polychloro-trifluoroethylene.

Among them, from the viewpoint of improving the gas barrier property, metals such as aluminum, magnesium, zinc, and tin, silicon compounds such as silicon nitride, silicon oxide, silicon oxynitride, a polysilazane compound, a polycarbosilane compound, a polysilane compound, a polyorganosiloxane compound, and a tetraorganosilane compound, aluminum compounds such as aluminum oxide and aluminum oxynitride, and inorganic oxides such as magnesium oxide, zinc oxide, indium oxide, and tin oxide are preferable, and from the viewpoint of the transparency, (1) a polysilazane compound, (2) a polycarbosilane compound, (3) a polysilane compound, (4) a polyorganosiloxane compound, and (5) a tetraorganosilane compound are more preferable.

Hereinafter, the details about the above-described (1) to (5) compounds will be described.

### ((1) Polysilazane Compound)

The polysilazane compound is a polymer having a repeating unit that includes a (-Si-N-) bond in the molecule, and examples thereof include a compound having a repeating unit represented by the following formula (1).

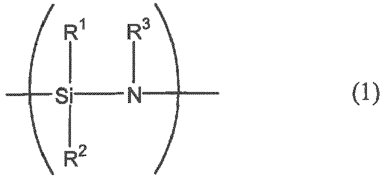

In the formula (1), R¹, R², and R³ each independently represent a hydrogen atom, or a non-hydrolyzable group such as an unsubstituted or substituted alkyl group, an unsubstituted or substituted cycloalkyl group, an unsubstituted or substituted alkenyl group, an unsubstituted or substituted aryl group, or an alkylsilyl group.

Among them, as R¹ to R³, any of a hydrogen atom, an alkyl group having 1 to 6 carbon atoms, and a phenyl group is preferable, and a hydrogen atom is more preferable.

As the polysilazane compound having a repeating unit represented by the formula (1), from the viewpoint of easy availability and capability of forming a layer having an excellent gas barrier property, inorganic polysilazanes in which R¹ to R³ are all hydrogen atoms, or organic polysilazanes in which at least one of R¹ to R³ is not a hydrogen atom are preferable, inorganic polysilazanes are more preferable, and perhydropolysilazane is further preferable.

The number average molecular weight of the polysilazane compound is not particularly limited, but it is preferably 100 to 50,000.

### ((2) Polycarbosilane Compound)

The polycarbosilane compound is a polymer compound having a repeating unit that includes a (-Si-C-) bond in the main chain of the molecule, and examples thereof include a compound having a repeating unit represented by the following formula (2).

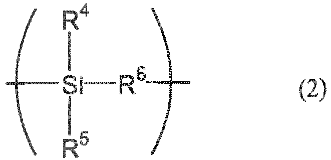

In the formula (2), R⁴ and R⁵ each independently represent a hydrogen atom, a hydroxyl group, an alkyl group, an aryl group, an aralkyl group, an alkenyl group, or a monovalent heterocyclic group. R⁴ and R⁵ each may be the same or different.

In addition, R⁶ represents an alkylene group, an arylene group, or a divalent heterocyclic group.

As the polycarbosilane compound having a repeating unit represented by the formula (2), those in which R⁴ and R⁵ each independently represent a hydrogen atom, an alkyl group, or an aryl group and R⁶ represents an alkylene group or an arylene group are preferable, those in which R⁴ and R⁵ each independently represent a hydrogen atom or an alkyl group and R⁶ represents an alkylene group are more preferable, and those in which R⁴ and R⁵ each independently represent a hydrogen atom or an alkyl group having 1 to 4 carbon atoms and R⁶ represents an alkylene group having 1 to 6 carbon atoms are further preferable.

The mass-average molecular weight of the polycarbosilane compound is usually 400 to 12,000.

### ((3) Polysilane Compound)

The polysilane compound is a polymer compound having a repeating unit that includes a (-Si-Si-) bond in the molecule. Examples of the polysilane compound include a compound having a repeating unit represented by the following formula (3).

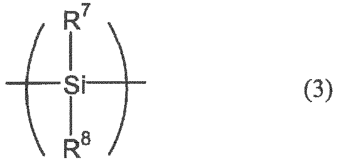

In the formula (3), R⁷ and R⁸ each independently represent a hydrogen atom, a hydroxyl group, an alkyl group, a cycloalkyl group, an alkenyl group, a cycloalkenyl group, an aryl group, an alkoxy group, a cycloalkyloxy group, an aryloxy group, an aralkyloxy group, an amino group that may have a substituent, a silyl group, or a halogen atom.

As the polysilane compound having a repeating unit represented by the formula (3), those in which R⁷ and R⁸ each independently represent a hydrogen atom, an alkyl group, an aryl group, a hydroxyl group, an alkoxy group, an amino group, or a silyl group are preferable, those in which R⁷ and R⁸ each independently represent a hydrogen atom, an alkyl group, or an aryl group are more preferable, and those in which R⁷ and R⁸ each independently represent an alkyl group having 1 to 4 carbon atoms or an aryl group are further preferable.

The form of the polysilane compound is not particularly limited, and may be homopolymers, such as acyclic polysilanes such as a straight-chain polysilane, a branched-chain polysilane, and a network polysilane, and a cyclic polysilane, and may also be copolymers such as a random copolymer, a block copolymer, an alternate copolymer, and a comb-shaped copolymer.

When the polysilane compound is an acyclic polysilane, the terminal group (terminal substituent) of the polysilane compound may be a hydrogen atom, or may also be a halogen atom such as a chlorine atom, an alkyl group, a hydroxyl group, an alkoxy group, a silyl group or the like.

The mass-average molecular weight of the polysilane compound is not particularly limited, and it is preferably 300 to 100,000, more preferably 400 to 50,000, and further preferably 500 to 30,000.

### ((4) Polyorganosiloxane Compound)

The main chain structure of the polyorganosiloxane compound is not limited, and the compound may have any of straight-chain, ladder-shaped and cage-shaped structures.

Examples of the compound having a straight-chain main chain structure include a compound having a repeating unit represented by the following formula (4), examples of the compound having a ladder-shaped main chain structure include a compound having a repeating unit represented by the following formula (5), and examples of the compound having a cage-shaped main chain structure include a compound having a repeating unit represented by the following formula (6).

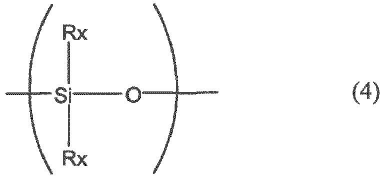

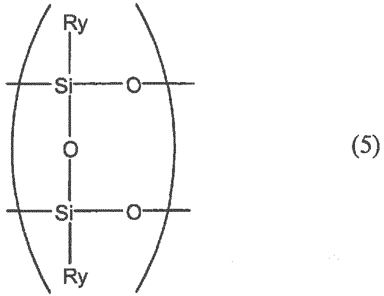

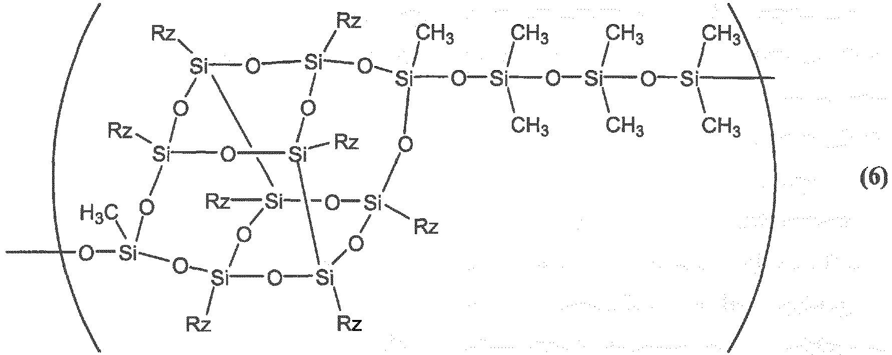

In the formulas (4) to (6), Rx, Ry, and Rz each represent a hydrogen atom, or a non-hydrolyzable group selected from an unsubstituted or substituted alkyl group, an unsubstituted or substituted alkenyl group, an unsubstituted or substituted aryl group or the like. Rx, Ry, and Rz in the formulas each may be the same or different, but two Rxs in the formula (4) are not hydrogen atoms at the same time.

Among them, Rx, Ry, and Rz each independently represent preferably an unsubstituted or substituted alkyl group having 1 to 6 carbon atoms or phenyl group, and more preferably a methyl group, an ethyl group, a propyl group, a 3-glycidoxypropyl group, or a phenyl group.

### ((5) Tetraorganosilane Compound)

The tetraorganosilane compound is a compound in which four hydrolyzable groups are bonded to the silicon element, and is specifically a compound represented by the formula (7): SiX₄.

In the formula (7): SiX₄, Xs represent hydrolyzable substituents, and may be the same or different from each other.

Examples of X include a group represented by the formula (8): OR (R represents a hydrocarbon group having 1 to 10 carbon atoms or an alkoxy group), a group represented by the formula (9): OSi(R^{a})(R^{b})(R^{c}) (R^{a}, R^{b}, and R^{c} each independently represent a hydrogen atom, an alkyl group having 1 to 10 carbon atoms, or a phenyl group), and a halogen atom such as a chlorine atom and a bromine atom.

Examples of the tetraorganosilane compound include tetra(C1 to C10)alkoxysilanes such as tetramethoxysilane, tetraethoxysilane, tetrapropoxysilane, tetraisopropoxysilane, and tetrabutoxysilane; tri(C1 to C10)alkoxyhalogenosilanes such as trimethoxychlorosilane, triethoxychlorosilane, and tripropoxychlorosilane; di(C1 to C10)dihalogenoalkoxysilanes such as dimethoxydichlorosilane, diethoxydichlorosilane, and dipropoxydichlorosilane; mono(C1 to C10)alkoxytrihalogenosilanes such as methoxytrichlorosilane, ethoxytrichlorosilane, and propoxytrichlorosilane; and tetrahalogenosilanes such as tetrachlorosilane and tetrabromosilane. Here, "(C1 to C10)" indicates that the number of carbon atoms is 1 to 10.

These tetraorganosilane compounds may be used singly or in combination of two or more kinds thereof.

Among them, from the viewpoint of excellent handleability and improving the gas barrier property, tetra(C1 to C10)alkoxysilanes are preferable. It is to be noted that these tetraorganosilane compounds are preferably subjected to hydrolysis/dehydration-condensation in a suitable solvent and in the presence of water and a catalyst as needed.

The mass-average molecular weight of the hydrolyzate or dehydrated condensate of the tetraorganosilane compound is not particularly limited, and from the viewpoint of forming a gas barrier layer which also excels in mechanical strength, it is preferably 200 to 50,000, more preferably 200 to 30,000, and further preferably 200 to 10,000. When the mass-average molecular weight is 200 or more, the compound has a sufficient film-forming capability, and when it is 50,000 or less, a film having sufficient mechanical strength can be formed.

A method for forming the gas barrier layer is not particularly limited, and examples thereof include a method in which a solution obtained by dissolving the above-described material in an organic solvent is applied onto the above-described substrate and the obtained coated film is moderately dried to form the layer. The applying method is not particularly limited, and examples thereof include known applying methods such as a spin coat method, a spray coat method, a bar coat method, a knife coat method, a roll coat method, a blade coat method, a die coat method, and a gravure coat method.

In addition, examples of other forming methods include a method in which the above-described material is formed on the substrate by a vapor deposition method, a sputtering method, an ion plating method, a thermal CVD method, a plasma CVD method or the like.

The thickness of the gas barrier layer to be formed is, from the viewpoint of the gas barrier performance and the handleability, preferably 20 nm to 100 µm, more preferably 30 to 500 nm, and further preferably 40 to 200 nm. It is to be noted that, in the present invention, even when the gas barrier layer is nano-order, the pressure-sensitive adhesive sheet having sufficient gas barrier performance can be formed.

Furthermore, from the viewpoint of obtaining the pressure-sensitive adhesive sheet which has a small value of the water vapor transmission rate and excels in the suppressing effect on moisture intrusion, the gas barrier layer is preferably one in which conversion treatment is performed with respect to the surface of a layer containing the above-described polysilazane compound.

Examples of the conversion treatment include ion injection treatment, plasma treatment, ultraviolet irradiation treatment, and heat treatment, and among them, ions are preferably injected. By injecting ions, the gas barrier performance can be improved while having high transparency. A step of injecting ions is not particularly limited, and examples thereof include a method of injecting ions into a gas barrier layer after forming the gas barrier layer formed on a substrate.

Examples of the ions to be injected include rare gases such as argon, helium, neon, krypton, and xenon; ions such as fluorocarbon, hydrogen, nitrogen, oxygen, carbon dioxide, chlorine, fluorine, and sulfur; and metal ions such as gold, silver, copper, platinum, nickel, palladium, chromium, titanium, molybdenum, niobium, tantalum, tungsten, and aluminum.

Among them, from the viewpoint of capable of more easily injecting ions and obtaining the pressure-sensitive adhesive sheet having especially excellent gas barrier performance and transparency, at least one kind of ions selected from the group consisting of hydrogen, nitrogen, oxygen, argon, helium, neon, xenon, and krypton is preferable.

It is to be noted that the amount of ions injected is arbitrarily selected in consideration of the intended use and the like of the pressure-sensitive adhesive sheet, such as the necessary gas barrier property and transparency.

Examples of a method for injecting ions include a method of irradiating the layer with ions (ion beams) accelerated by an electric field and a method of injecting ions in plasma into the layer (plasma ion injection method). Among them, from the viewpoint of easily obtaining the pressure-sensitive adhesive sheet having an excellent gas barrier property and the like, the plasma ion injection method is preferable.

The plasma ion injection method can be performed by generating plasma under an atmosphere containing plasma-forming gas and applying a negative high-voltage pulse to the gas barrier layer to inject ions (cations) in the plasma into the surface part of the gas barrier layer.

The thickness of the part into which ions are injected can be controlled depending on the injection conditions such as the kind of ions, the applied voltage, and treating time, and may be determined in accordance with the thickness of the gas barrier layer, the intended use of the pressure-sensitive adhesive sheet and the like, and it is usually 10 to 1,000 nm and preferably 10 to 200 nm.

The water vapor transmission rate at 40°C and 90% RH (relative humidity) of the thus-obtained gas barrier film is preferably 0.5 g/m²/day or less, and more preferably 0.05 g/m²/day or less.

It is to be noted that the transmission rate of water vapor or the like through the gas barrier film can be measured using a known gas transmission rate-measuring apparatus.

### <Release Sheet>

As the release sheet, a release sheet whose both surfaces are subjected to peeling treatment and a release sheet whose one surface is subjected to peeling treatment are used, and examples thereof include one in which a peeling agent is applied on a substrate for a release sheet.

Examples of the substrate for a release sheet include paper substrates such as glassine paper, coated paper, and high-quality paper, laminated paper obtained by laminating a thermoplastic resin such as polyethylene on these paper substrates, or plastic films such as polyester resin films made of a polyethylene terephthalate resin, a polybutylene terephthalate resin, a polyethylene naphthalate resin and the like, and polyolefin resin films made of a polypropylene resin, a polyethylene resin and the like.

Examples of the peeling agent include rubber-based elastomers such as a silicone-based resin, an olefin-based resin, an isoprene-based resin, and a butadiene-based resin, a long-chain alkyl-based resin, an alkyd-based resin, and a fluorine-based resin.

The thickness of the release sheet is not particularly limited, but it is preferably 20 to 200 µm, and more preferably 25 to 150 µm.

### [Manufacturing Method of Pressure-sensitive adhesive sheet of Present Invention]

A manufacturing method of the pressure-sensitive adhesive sheet of the present invention is not particularly limited, and the pressure-sensitive adhesive sheet can be manufactured by a known method. Examples thereof include a method in which the solution of the pressure-sensitive adhesive composition, obtained by adding an organic solvent to the above-described pressure-sensitive adhesive composition, is applied by a known applying method to manufacture an pressure-sensitive adhesive sheet.

An organic solvent such as toluene, ethyl acetate, or methyl ethyl ketone may be further blended into the pressure-sensitive adhesive composition of the present invention to give a solution of the pressure-sensitive adhesive composition.

The solid content of the solution of the pressure-sensitive adhesive composition when the organic solvent is blended is preferably 10 to 60 mass%, more preferably 10 to 45 mass%, and further preferably 15 to 30 mass%. When it is 10 mass% or more, the amount of the organic solvent used is sufficient, and when it is 60 mass% or less, the solution has a moderate viscosity and excellent application workability.

Examples of the applying method include a spin coat method, a spray coat method, a bar coat method, a knife coat method, a roll coat method, a roll knife coat method, a blade coat method, a die coat method, and a gravure coat method.

Examples of specific manufacturing methods include the following methods depending on the structure of the pressure-sensitive adhesive sheet.

The pressure-sensitive adhesive sheet 1a having a pressure-sensitive adhesive layer on one surface of a substrate, as in Fig. 1(a), can be manufactured, for example, by directly applying the above-described solution of the pressure-sensitive adhesive composition onto one surface of the substrate 11 to form the pressure-sensitive adhesive layer 12. In addition, it can also be manufactured by attaching a pressure-sensitive adhesive layer exposed by removing both release sheets of the two-sided pressure-sensitive adhesive sheet 1d, as in Fig. 1(d), to one surface of the substrate 11.

The pressure-sensitive adhesive sheet 1b having a pressure-sensitive adhesive layers on both surfaces of a substrate, as in Fig. 1(b), can be manufactured, for example, by directly applying the solution of the pressure-sensitive adhesive composition onto both surfaces of the substrate 11 to form the pressure-sensitive adhesive layers 12a, 12b. In addition, it can also be manufactured by attaching a pressure-sensitive adhesive layer exposed by removing one release sheet of the two-sided pressure-sensitive adhesive sheet 1d, as in Fig. 1(d), to one surface of the substrate 11, and directly applying the solution of the pressure-sensitive adhesive composition onto the other surface of the substrate 11.

The pressure-sensitive adhesive sheet 1c having a pressure-sensitive adhesive layer and a release sheet in this order on a substrate, as in Fig. 1(c), can be manufactured, for example, by laminating the release sheet 13 on the adhesive agent surface of the pressure-sensitive adhesive sheet 1a obtained as described above. In addition, it can be manufactured by attaching the pressure-sensitive adhesive layer 12 formed by directly applying the above-described solution of the pressure-sensitive adhesive composition onto the peeling-treated surface of the release sheet 13, to the substrate 11.

The pressure-sensitive adhesive sheet 1d having a structure in which the pressure-sensitive adhesive layer 12 is sandwiched between two release sheets not using a substrate, as in Fig. 1(d), can be manufactured, for example, by attaching the pressure-sensitive adhesive layer 12 formed by directly applying the above-described solution of the pressure-sensitive adhesive composition onto the peeling-treated surface of the release sheet 13a, to the release sheet 13b. In addition, it can also be manufactured as a one-layer tape-shaped two-sided adhesive tape not having a substrate, by directly applying the above-described solution of the pressure-sensitive adhesive composition onto one surface of the release sheet whose both surfaces are peeling-treated and winding it into a roll shape. It is to be noted that, as described above, it is preferable to adjust such that the peel force between the release sheet 13a and the release sheet 13b is different.

### [Intended Use of Pressure-sensitive adhesive sheet of Present Invention]

The pressure-sensitive adhesive sheet having the pressure-sensitive adhesive layer formed from the pressure-sensitive adhesive composition of the present invention has excellent adhesive force, excels in the suppressing effect on moisture intrusion, has good transparency, and can lower the amount of outgas generated.

Therefore, the pressure-sensitive adhesive sheet of the present invention is suitable as a sealing member of an organic EL element or the like, and when the pressure-sensitive adhesive sheet of the present invention is used as a sealing member, peeling-off of the pressure-sensitive adhesive sheet due to moisture intrusion and heat generated during driving of an organic EL element can be suppressed, and property degradation of the organic EL element can be suppressed.

Specifically, the pressure-sensitive adhesive sheet of the present invention can be used as a sealing member for electronic devices, for example, organic devices such as an organic transistor, an organic memory, and an organic EL element; liquid crystal displays; electronic paper; thin film transistors; electrochromic devices; electrochemical light-emitting devices; touch panels; solar batteries; thermoelectric conversion devices; piezoelectric conversion devices; electric storage devices; and the like.

Among them, the pressure-sensitive adhesive sheet of the present invention is preferably used for sealing an organic EL element.

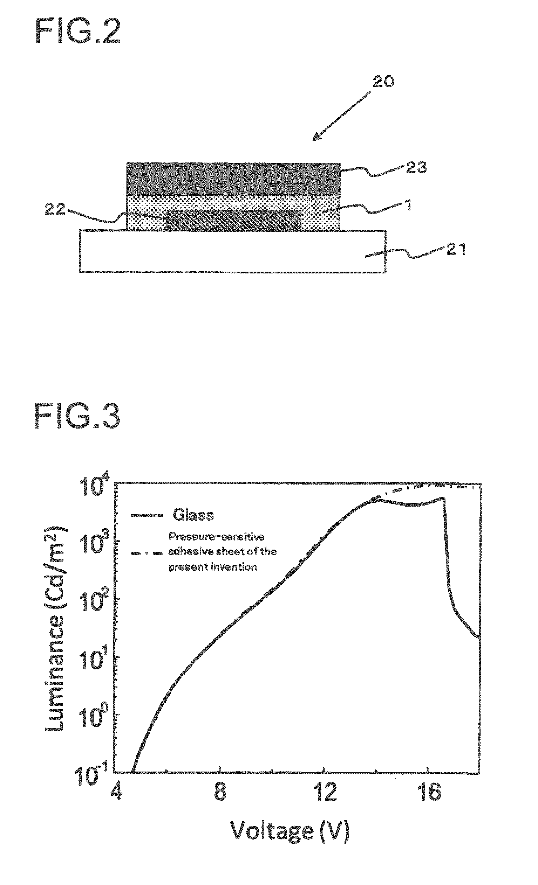

An example of an organic EL element sealed with the pressure-sensitive adhesive sheet of the present invention is shown in Fig. 2. It is to be noted that, hereinafter, sealing of an organic EL element will be described, but the pressure-sensitive adhesive sheet of the present invention can be suitably used for sealing the above-described various electronic devices without limiting to organic devices such as an organic EL element.

In an organic EL element 20, a structure 22 is formed on a glass substrate 21. The structure 22 is one in which a transparent electrode, a hole transport layer, a light emitting layer, a back electrode and the like are laminated. The pressure-sensitive adhesive sheet 1 of the present invention is laminated on the structure 22 and the glass substrate 21, and a gas barrier film 23 is further fixed onto the pressure-sensitive adhesive sheet 1. The pressure-sensitive adhesive layer of the pressure-sensitive adhesive sheet 1 of the present invention is firmly attached and fixed to the structure 22 and the glass substrate 21 to give the sealed organic EL element 20. By using the pressure-sensitive adhesive sheet of the present invention, an organic EL element can be easily sealed without the need for treatment such as high-temperature heating and ultraviolet irradiation.

In addition, the property of the organic EL element sealed with the pressure-sensitive adhesive sheet of the present invention will be described using Fig. 3. Fig. 3 is a diagram showing the relationship between the voltage and the light emission luminance of the organic EL element sealed with the pressure-sensitive adhesive sheet of the present invention or glass. In the organic EL element sealed with glass, heat is generated in the structure of the organic EL element with increasing the voltage, the element is destroyed by the heat, and a decrease in the light emission luminance is observed. On the other hand, in the pressure-sensitive adhesive sheet of the present invention, the heat generated in the structure can be transferred to the outside, and thus, a decrease in the light emission luminance can be suppressed even when increasing the voltage.

### Examples

The mass-average molecular weight (Mw) and the softening point of components used in Examples and Comparative Examples below are values measured by methods described below.

### <Mass-Average Molecular Weight (Mw)>

A value in terms of standard polystyrene, which was measured using a gel permeation chromatograph apparatus (manufactured by Tosoh Corporation, product name "HLC-8020") under the following conditions, was used.

### (Measurement Conditions)

- Column: "TSK guard column HXL-H" "TSK gel GMHXL (x2)" "TSK gel G2000HXL" (all manufactured by Tosoh Corporation)
- Column Temperature: 40°C
- Developing Solvent: Tetrahydrofuran
- Flow Rate: 1.0 mL/min

### <Softening Point>

A value measured in conformity with JIS K 2531 was used.

The respective physical properties and properties of the pressure-sensitive adhesive sheets measured using the pressure-sensitive adhesive sheets with a substrate or the pressure-sensitive adhesive sheets without a substrate manufactured in Examples and Comparative Examples described below were measured and evaluated based on the following methods.

### <Adhesive Force>

The pressure-sensitive adhesive sheet with a substrate manufactured in Examples and Comparative Examples was cut into a size of 25 mmx300 mm, and under the environment at 23°C and 50% RH (relative humidity), a light release sheet was peeled off and the pressure-sensitive adhesive sheet was attached to the adherend below. In the attaching, after the pressure-sensitive adhesive sheet was attached to the adherend, a roller having a weight of 2 kg was used and moved once back and forth on the pressure-sensitive adhesive sheet so that the adherend and the pressure-sensitive adhesive sheet were temporarily pressure-bonded, and they were laminated at 80°C using a laminator.

After that, it was left at rest under the environment at 23°C and 50% RH for 24 hours after the attaching, under the same environment, the adhesive force (N/25 mm) with respect to each adherend was measured using a tensile tester (manufactured by ORIENTEC Co., LTD, product name "Tensilon") under the conditions of a peel rate of 300 mm/min and a peel angle of 180°.

The adherend used in the measurement of the adhesion force was as follows ([] indicates the abbreviation in Tables below).
- Soda-lime glass [glass]: manufactured by NSG Precision Co., Ltd, product name "Corning Glass Eagle XG" 150 mmx70 mmx2 mm.
- Stainless plate [SUS]: SUS304 steel plate, #360 polished.

### <Visible Light Transmittance>

The pressure-sensitive adhesive layer exposed by peeling off a light release sheet of the pressure-sensitive adhesive sheet without a substrate manufactured in Examples and Comparative Examples was attached to a glass plate (manufactured by NSG Precision Co., Ltd, product name "Corning Glass Eagle XG" 150 mmx70 mmx2 mm). Then, a heavy release sheet of the pressure-sensitive adhesive sheet without a substrate was peeled off to obtain a pressure-sensitive adhesive sheet with a glass plate whose pressure-sensitive adhesive layer is exposed.

The visible light transmittance at a wavelength of 550 nm of the pressure-sensitive adhesive layer of the pressure-sensitive adhesive sheet with a glass plate was measured using a visible light transmittance measuring apparatus (manufactured by Shimadzu Corporation, product name "UV-3101PC").

### <Amount of Outgas Generated>

The pressure-sensitive adhesive sheet without a substrate manufactured in Examples and Comparative Examples was cut into a size of 20 cm².

Subsequently, the pressure-sensitive adhesive layer of the pressure-sensitive adhesive sheet whose both surfaces are exposed by removing a light release sheet and a heavy release sheet was sealed in an ampoule, the ampoule was heated at 120°C for 30 minutes using Purge & Trap GC Mass (manufactured by JEOL Ltd., product name "JHS-100A"), and the generated gas was collected.

After that, the amount of the generated gas was calculated as the amount in terms of n-decane (µg/cm²) based on the calibration curve formed with n-decane, using GC Mass (manufactured by PERKIN ELMER, product name "Turbo Mass").

### <Moisture Intrusion Test>

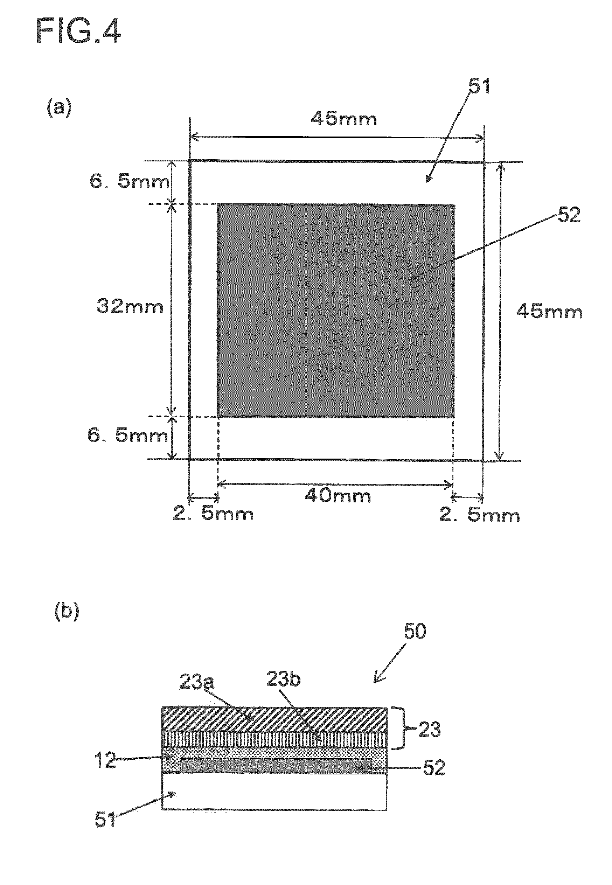

Fig. 4 is (a) a plan view and (b) a front view (cross-sectional view) of a test laminate used for the moisture intrusion test of the pressure-sensitive adhesive sheet.

Firstly, on a glass substrate 51 having a size shown in Fig. 4(a), a calcium layer 52 having 32 mm vertical×40 mm horizontal and a film thickness of 100 nm was formed by a vacuum vapor deposition method.

Next, a gas barrier film 23 in which an aluminum layer 23b is attached onto a polyethylene terephthalate (PET) film 23a with an adhesive agent (manufactured by ASIA ALUMINUM CO., LTD, product name "ALPET7x38", aluminum layer : 7 µm, PET film: 38µm) was separately prepared.

The pressure-sensitive adhesive layer 12 exposed by peeling off a light release sheet of the pressure-sensitive adhesive sheet without a substrate manufactured in Examples and Comparative Examples was attached to the aluminum layer 23b of the above-described gas barrier film 23 under the environment at 23°C and 50% RH (relative humidity).

Then, the pressure-sensitive adhesive layer 12 exposed by peeling off a heavy release sheet of the pressure-sensitive adhesive sheet without a substrate was attached to the glass substrate 51 and the calcium layer 52 in a nitrogen atmosphere using a heating laminator (heating temperature: 80°C). In this manner, the test laminate 50 in which the calcium layer 52 is sealed with the pressure-sensitive adhesive layer 12 of the pressure-sensitive adhesive sheet was manufactured (refer to Fig. 4(b)).

The manufactured test laminate 50 was left at rest for 24 hours, 72 hours, 100 hours, and 170 hours under the environment at 60°C and 90% RH (relative humidity), and then, the ratio of color change of the calcium layer (ratio of moisture intrusion) due to moisture intrusion was visually observed and evaluated according to the following standards.

It is to be noted that, when the evaluation result C was obtained while the test laminate 50 was left at rest for the above-described hours, the test was finished without performing evaluation thereafter.
- A: The area of the calcium layer whose color is changed due to moisture intrusion is less than 20% of the total.
- B: The area of the calcium layer whose color is changed due to moisture intrusion is 20% or more and less than 60% of the total.
- C: The area of the calcium layer whose color is changed due to moisture intrusion is 60% or more of the total.

### <Water Vapor Transmission Rate>

A test sample was manufactured as described below, by using three pressure-sensitive adhesive sheets without a substrate manufactured in Examples and Comparative Examples.

Firstly, a polyethylene terephthalate (PET) film (manufactured by Mitsubishi Plastics, Inc., thickness: 6 µm) was laminated on the surface of the pressure-sensitive adhesive layer exposed by peeling off a light release sheet of the first pressure-sensitive adhesive sheet without a substrate manufactured in Examples and Comparative Examples.

Next, the pressure-sensitive adhesive layer exposed by peeling off a heavy release sheet of the first pressure-sensitive adhesive sheet without a substrate was attached to the pressure-sensitive adhesive layer exposed by peeling off a light release sheet of the second pressure-sensitive adhesive sheet without a substrate manufactured in Examples and Comparative Examples.

Furthermore, the pressure-sensitive adhesive layer exposed by peeling off a heavy release sheet of the second pressure-sensitive adhesive sheet without a substrate was attached to the pressure-sensitive adhesive layer exposed by peeling off a light release sheet of the third pressure-sensitive adhesive sheet without a substrate manufactured in Examples and Comparative Examples so that three pressure-sensitive adhesive layers each having a thickness of 20 µm were overlapped.

Finally, the pressure-sensitive adhesive layer exposed by peeling off a heavy release sheet of the third pressure-sensitive adhesive sheet without a substrate was attached to and laminated by a PET film (manufactured by Mitsubishi Plastics, Inc., thickness 6 µm) so that the test sample for measuring a water vapor transmission rate, in which the pressure-sensitive adhesive layers having a thickness of 60 µm are sandwiched between the two PET films, was manufactured.

The water vapor transmission rate of the manufactured test sample for measuring a water vapor transmission rate was measured under the environment at 40°C and 90% RH (relative humidity) using a transmission rate measuring instrument (manufactured by LYSSY, product name "L89-500").

It is to be noted that the water vapor transmission rate of the two PET films used for lamination was 43 g/m²/day. In other words, when the pressure-sensitive adhesive layer has no water vapor barrier property, the water vapor transmission rate of the test sample to be measured could be a value around 43 g/m²/day. When the value becomes smaller, the water vapor barrier property of the pressure-sensitive adhesive layer becomes better.

### <Total Light Transmittance, Haze>

The pressure-sensitive adhesive layer exposed by peeling off a light release sheet of the pressure-sensitive adhesive sheet without a substrate manufactured in Examples and Comparative Examples was attached to a glass plate (manufactured by NSG Precision Co., Ltd, product name "Corning Glass Eagle XG" 150 mmx70 mmx2 mm). Then, a heavy release sheet of the pressure-sensitive adhesive sheet without a substrate was peeled off to obtain a pressure-sensitive adhesive sheet with a glass plate whose pressure-sensitive adhesive layer is exposed.

Then, the total light transmittance of the pressure-sensitive adhesive sheet with a glass plate was measured using a haze meter (manufactured by NIPPON DENSHOKU INDUSTRIES CO., LTD., product name "NDH-2000") in conformity with JIS K 7361-1.

In addition, the haze of the pressure-sensitive adhesive sheet with a glass plate was measured using the above-described haze meter in conformity with JIS K 7136.

### [Examples 1A to 5A]

### (1) Preparation of Solution of Pressure-sensitive adhesive composition

The components (A) to (C) of the kinds and the amounts blended (solid content basis) shown in Table 1 were added and dissolved in toluene to prepare solutions of the pressure-sensitive adhesive composition having a solid content of 20 mass%.

It is to be noted that the details about the components (A) to (C) shown in Table 1 used in Examples 1A to 5A are as follows.

### <(A) Component>

- "Oppanol B50" (product name, manufactured by BASF): mass-average molecular weight of 340000.
- "Oppanol B30" (product name, manufactured by BASF): mass-average molecular weight of 200000.

### <(B) Component>

."P-907Y" (product name, manufactured by TOYO ADL CORPORATION): mixed resin containing SEBS and SEB, content of SEBS and SEB=30 mass%, softening point=112°C.
."P-907NA" (product name, manufactured by TOYO ADL CORPORATION): mixed resin containing SEBS and SEB, content of SEBS and SEB=20 mass%, softening point=128°C.

It is to be noted that the content of the component (B) in Table 1 indicates the content (solid content basis) of the sum of SEBS and SEB contained in P-907Y or P-907NA, with respect to 100 parts by mass of the component (A).

### <(C) Component>

."ARKON P-125" (product name, manufactured by Arakawa Chemical Industries, Ltd.): hydrogenated petroleum resin (alicyclic saturated hydrocarbon resin), softening point: 125°C.

### (2) Manufacture of Pressure-sensitive adhesive sheet with Substrate

The above-described prepared solution of the pressure-sensitive adhesive composition was applied onto a polyethylene terephthalate (PET) film (manufactured by TOYOBO CO., LTD, product name "COSMOSHINE A4100", thickness 50 µm), which is a substrate, such that the thickness after drying is 20 µm to form an applied film, and the applied film was dried at 120°C for 2 minutes to form a pressure-sensitive adhesive layer having a thickness of 20 µm.

Next, a peeling-treated surface of a PET film (manufactured by Lintec Corporation, product name "SP-PET381130", thickness 38 µm) whose surface is silicone peeling-treated, which is a light release sheet, was attached onto the surface of the formed pressure-sensitive adhesive layer to manufacture an pressure-sensitive adhesive sheet with a substrate, which has the same structure as the pressure-sensitive adhesive sheet 1c of Fig. 1(c).

### (3) Manufacture of Pressure-sensitive adhesive sheet without Substrate

The above-described prepared solution of the pressure-sensitive adhesive composition was applied onto a peeling-treated surface of a PET film (manufactured by Lintec Corporation, product name "SP-PET38T103-1", thickness 38 µm) whose surface is silicone peeling-treated, which is a heavy release sheet, such that the thickness after drying is 20 µm to form an applied film, and the applied film was dried at 120°C for 2 minutes to form a pressure-sensitive adhesive layer having a thickness of 20 µm.

Next, a peeling-treated surface of a PET film (manufactured by Lintec Corporation, product name "SP-PET381130", thickness 38 µm) whose surface is silicone peeling-treated, which is a light release sheet, was attached onto the surface of the formed pressure-sensitive adhesive layer to manufacture an pressure-sensitive adhesive sheet without a substrate sandwiched between two release sheets, which has the same structure as the pressure-sensitive adhesive sheet 1d of Fig. 1(d).

### [Comparative Example 1A]

100 parts by mass (solid content) of a styrene-isobutylene-styrene triblock copolymer (SIS) (manufactured by Zeon Corporation, product name "Quintac3421", styrene content: 14 mass%, Mw: 120,000) was dissolved in toluene to prepare a solution of the pressure-sensitive adhesive composition having a solid content of 20 mass%.

A pressure-sensitive adhesive sheet with a substrate and a pressure-sensitive adhesive sheet without a substrate were manufactured using the prepared solution of the pressure-sensitive adhesive composition, in the same manner as Examples 1A to 5A.

### [Comparative Example 2A]

As monomer components, 90 parts by mass of butyl acrylate and 10 parts by mass of acrylic acid, and as a polymerization initiator, 0.2 parts by mass of azobisisobutyronitrile were put into a reactor and mixed. This was purged with nitrogen gas for 4 hours, and after the temperature was gradually increased to 60°C, a polymerization reaction was performed while stirring for 24 hours to obtain an ethyl acetate solution (solid content 33 mass%) containing an acrylic-based copolymer (Mw: 650,000).

1.5 parts by mass (solid content basis) of an isocyanate-based cross-linking agent (manufactured by Nippon Polyurethane Industry Co., Ltd., product name "CORONATE L", ethyl acetate solution of trimethylolpropane-modified tolylene diisocyanate, solid content 75 mass%) was added to 100 parts by mass (solid content) of the obtained ethyl acetate solution of an acrylic-based copolymer and dissolved in toluene to prepare a solution of the pressure-sensitive adhesive composition having a solid content of 20 mass%.

Then, a pressure-sensitive adhesive sheet with a substrate and an pressure-sensitive adhesive sheet without a substrate were manufactured using the prepared solution of the pressure-sensitive adhesive composition, in the same manner as Examples 1A to 5A.

The adhesive force, the visible light transmittance, the amount of outgas generated, and the moisture intrusion test of the pressure-sensitive adhesive sheet were measured and evaluated based on the above-described methods, using the pressure-sensitive adhesive sheets with a substrate or the pressure-sensitive adhesive sheets without a substrate manufactured in Examples 1A to 5A and Comparative Examples 1A to 2A. The results are shown in Table 1.

**Table 1**

| | | Mw or Softening Point | Example 1A | Example 2A | Example 3A | Example 4A | Example 5A | Comparative Example 1A | Comparative Example 2A |
|---|---|---|---|---|---|---|---|---|---|
| (A) Component ^{*1} | Oppanol B50 | Mw: 340000 | 90.9 | 90.9 | 90.9 | 90.9 | 90.9 | SIS Copolymer | Acrylic-Based Copolymer |
| | Oppanol B30 | Mw: 200000 | 9.1 | 9.1 | 9.1 | 9.1 | 9.1 | | |
| (B) Component *^{1,2} | P-907Y | Softening Point: 112°C | 10.2 | 40.9 | 81.7 | - | - | | |
| | P-907NA | Softening Point: 128°C | - | - | - | 11.8 | 23.6 | | |
| (C) Component ^{*1} | ARKON P-125 | Softening Point: 125°C | 18.2 | 18.2 | 18.2 | 18.2 | 18.2 | | |
| Resins other than Component(A) to (C) contained in P-907Y or P-907NA | | | 23.8 | 95.3 | 190.6 | 47.3 | 94.5 | | |
| Adhesive Force (N/25 mm) | 23°C, 50%RH | SUS | 20.6 | 22.0 | 23.2 | 19.8 | 20.2 | 13.6 | 11.6 |
| | | Glass | 20.8 | 22.3 | 23.2 | 21.5 | 21.2 | 9.3 | 15.2 |
| Visible Light Transmittance (%) | | | 91 | 91 | 91 | 91 | 91 | 90 | 91 |
| Amount of Outgas Generated (µg/cm²) | | | 0.1 | 0.1 | 0.1 | 0.1 | 0.1 | 0.3 | 0.2 |
| Moisture Intrusion Test | | 24 Hours Later | A | A | A | A | A | B | B |
| | | 70 Hours Later | A | A | A | A | A | C | C |
| | | 100 Hours Later | A | A | A | A | A | (*3) | (*3) |
| | | 170 Hours Later | A | A | A | A | A | (*3) | (*3) |

| | | | | | | | | | |
|---|---|---|---|---|---|---|---|---|---|
| *1: The amount of each component blended is indicated in "parts by mass" based on the solid content. *2: The content of the component (B) is indicated by the content (solid content basis) of the sum of SEBS and SEB contained in commercial P-907Y or P-907NA. *3: Since the evaluation result after 70 hours was "C", the test was finished without performing the tests thereafter. | | | | | | | | | |

The pressure-sensitive adhesive sheets of Examples 1A to 5A resulted in having excellent adhesive force, high visible light transmittance, and the extremely-low amount of outgas generated. In addition, according to the result of the moisture intrusion test, it is considered that the suppressing effect on moisture intrusion is high, peeling-off of the pressure-sensitive adhesive sheet can be suppressed, and property degradation of an organic EL element or the like can be suppressed.

On the other hand, according to the result of the moisture intrusion test, the pressure-sensitive adhesive sheets of Comparative Examples 1A and 2A resulted in having insufficient suppressing effect on moisture intrusion compared to the pressure-sensitive adhesive sheets of Examples.

### [Examples 1B to 9B, Comparative Examples 1B to 5B]

The components (A) to (C) of the kinds and the amounts blended (solid content basis) shown in Table 2 were added and dissolved in toluene to prepare solutions of the pressure-sensitive adhesive composition having a solid content of 20 mass%.

Then, pressure-sensitive adhesive sheets with a substrate and pressure-sensitive adhesive sheets without a substrate were manufactured using these prepared solutions of the pressure-sensitive adhesive composition, in the same manner as Examples 1A to 5A described above.

It is to be noted that the details about the components (A) to (C) in Table 2 are as follows.

### <(A) Component>

."PIB resin mixture": polyisobutylene-based resin mixture containing "Oppanol B50 (product name, manufactured by BASF, polyisobutylene-based resin having Mw of 340,000)"/"Oppanol B30 (product name, manufactured by BASF, polyisobutylene-based resin having Mw of 200,000)" at a ratio of 10/1 (mass ratio).

### <(B) Component>

."KratonG1726" (product name, manufactured by Kraton Performance Polymers Inc.): styrene-based copolymer mixture containing SEBS (Mw: 70,000)/SEB (Mw: 35,000) at a ratio of 30/70 (mass ratio). styrene content: 30 mass%.

### <(C) Component>

."Quinton R-100" (product name, manufactured by Zeon Corporation): aliphatic hydrocarbon resin (petroleum resin manufactured mainly from high-purity 1,3-pentadiene extracted from C5 fraction), softening point: 96°C.

The adhesive force, the water vapor transmission rate, the total light transmittance, and the haze of the pressure-sensitive adhesive sheet were measured based on the above-described methods, using the pressure-sensitive adhesive sheets with a substrate or the pressure-sensitive adhesive sheets without a substrate manufactured in Examples 1B to 9B and Comparative Examples 1B to 5B described above, and Comparative Examples 1A to 2A described above. The results are shown in Table 2.

**Table 2**

| | Pressure-sensitive adhesive composition (Parts by Mass (Solid content basis)) | | | Evaluation Items | | | | |
|---|---|---|---|---|---|---|---|---|
| | (A) Component | (B) Component | (C) Component | Adhesive (N/25 | Force mm) | Water Vapor Transmission Rate (g/m2/day) [40°C, 90%RH] | Total Light Transmittance (%) | Haze (%) |
| | PIB-Based Resin Mixture (*) | Kraton G1726 | Quinton R100 (Softening Point: 96°C) | Glass | SUS | | | |
| Example 1B | 90 | 10 | 10 | 13.5 | 13.7 | 3.8 | 91.4 | 0.63 |
| Example 2B | 90 | 10 | 30 | 18.2 | 17.9 | 4.2 | 91.4 | 0.58 |
| Example 3B | 90 | 10 | 50 | 23.0 | 22.4 | 4.4 | 91.4 | 0.57 |
| Example 4B | 80 | 20 | 10 | 13.2 | 12.9 | 4.1 | 91.4 | 0.67 |
| Example 5B | 80 | 20 | 30 | 17.3 | 17.3 | 4.5 | 91.4 | 0.60 |
| Example 6B | 80 | 20 | 50 | 19.2 | 21.9 | 4.8 | 91.4 | 0.61 |
| Example 7B | 70 | 30 | 10 | 16.5 | 12.8 | 4.3 | 91.4 | 0.71 |
| Example 8B | 70 | 30 | 30 | 14.4 | 18.6 | 4.4 | 91.8 | 0.69 |
| Example 9B | 75 | 25 | 40 | 22.7 | 23.6 | 3.8 | 91.3 | 0.53 |
| Comparative Example 1B | 100 | - | - | 8.2 | 8.3 | 2.1 | 91.4 | 0.69 |
| Comparative Example 2B | - | 100 | - | 0.1 | 0.04 | 13.7 | 91.3 | 1.54 |
| Comparative Example 3B | - | 100 | 10 | 12.6 | 0.2 | 12.9 | 91.3 | 1.33 |
| Comparative Example 4B | - | 100 | 30 | 17.0 | 13.2 | 12.0 | 91.3 | 0.78 |
| Comparative Example 5B | - | 100 | 50 | 18.5 | 18.3 | 11.5 | 91.3 | 0.74 |
| Comparative Example 1A | SIS | | | 9.3 | 13.6 | 41.0 | 91.1 | 1.45 |
| Comparative Example 2A | Acrylic-Based Copolymer | | | 15.2 | 11.6 | 20.1 | 91.8 | 0.51 |

| | | | | | | | | |
|---|---|---|---|---|---|---|---|---|
| (*) PIB-Based Resin Mixture of Oppanol B50 (PIB-Based Resin, Mw: 340000)/Oppanol B30 (PIB-Based Resin, Mw: 200000)=10/1. | | | | | | | | |

The pressure-sensitive adhesive sheets of Examples 1B to 9B had excellent adhesive force, high total light transmittance, and low haze, and thus, had good transparency. In addition, since the water vapor transmission rate of the pressure-sensitive adhesive layers is kept low, it is considered that the pressure-sensitive adhesive sheets of Examples 1B to 9B excel in the suppressing effect on moisture intrusion, and can suppress property degradation of an organic EL element or the like.

On the other hand, while keeping the water vapor transmission rate low, the pressure-sensitive adhesive sheet of Comparative Example 1B resulted in poor adhesive force compared to the pressure-sensitive adhesive sheets of the present Examples 1B to 9B.

In addition, since the pressure-sensitive adhesive layers in the pressure-sensitive adhesive sheets of Comparative Examples 2B to 5B and Comparative Examples 1A to 2A resulted in having high water vapor transmission rate compared to the pressure-sensitive adhesive layers in the pressure-sensitive adhesive sheets of Examples 1B to 9B, it is considered that, even when these pressure-sensitive adhesive sheets are used for sealing an organic EL element or the like, the suppressing effect on moisture intrusion is insufficient and therefore it is difficult to suppress property degradation of the organic EL element or the like.

### [Examples 1C to 26C, Comparative Examples 1C to 11C]

The components (A) to (C) and the tackifier of the kinds and the amounts blended (solid content basis) shown in Table 3-1 or Table 3-2 were added and dissolved in toluene to prepare solutions of the pressure-sensitive adhesive composition having a solid content of 20 mass%.

Then, pressure-sensitive adhesive sheets with a substrate and pressure-sensitive adhesive sheets without a substrate were manufactured using these prepared solutions of the pressure-sensitive adhesive composition, in the same manner as Examples 1A to 5A described above.

It is to be noted that the details about the components (A) to (C) and the tackifier in Table 3-1 and Table 3-2 are as follows.

### <(A) Component>

."isobutylene-isoprene copolymer": manufactured by JAPAN BUTYL Co., Ltd., product name "Exxon Butyl 268", Mw: 260,000, content of structural unit derived from isobutylene: 98.3 mol%, content of structural unit derived from isoprene: 1.7 mol%.

### <(B) Component>

."KratonG1726" (product name, manufactured by Kraton Performance Polymers Inc.): styrene-based copolymer mixture containing SEBS (Mw: 70,000)/SEB (Mw: 35,000) at a ratio of 30/70 (mass ratio), styrene content: 30 mass%.
."SIBSTAR 103T" (product name, manufactured by Kaneka Corporation): SIBS, Mw: 100,000, styrene content: 30 mass%.
."SIBSTAR 062M" (product name, manufactured by Kaneka Corporation): SIBS, Mw: 60,000, styrene content: 20 mass%, softening point: 96°C.

### <(C) Component>

."Quinton A-100" (product name, manufactured by Zeon Corporation): aliphatic hydrocarbon resin, softening point: 100°C.

### <Tackifier>

."I-MARV P-140" (product name, manufactured by Idemitsu Kosan Co., Ltd.): copolymer resin of dicyclopentadiene and aromatic vinyl monomer, softening point: 140°C.

The adhesive force, the water vapor transmission rate, the total light transmittance, and the haze of the pressure-sensitive adhesive sheet were measured based on the above-described methods, using the pressure-sensitive adhesive sheets with a substrate or the pressure-sensitive adhesive sheets without a substrate manufactured in Examples 1C to 26C and Comparative Examples 1C to 11C described above. The results are shown in Table 3-1 and Table 3-2.

**Table 3-1**

| | Pressure-sensitive adhesive composition (Parts by Mass (Solid content basis)) | | | Evaluation Items | | | | |
|---|---|---|---|---|---|---|---|---|
| | (A) Component | (B) Component | (C) Component | Adhesive Force (N/25 mm) | | Water Vapor Transmission Rate (g/m²/day) [40°C, 90%RH] | Total Light Transmittance (%) | Haze (%) |
| | Isobutylene-Isoprene Copolymer | Kraton G1726 | Quinton A100 (Softening Point: 100°C) | Glass | SUS | | | |
| Example 1C | 70 | 30 | 10 | 13.2 | 12.8 | 3.3 | 91.3 | 0.70 |
| Example 2C | 70 | 30 | 20 | 14.4 | 12.9 | 3.3 | 91.6 | 0.86 |
| Example 3C | 60 | 40 | 10 | 12.2 | 12.2 | 3.6 | 91.3 | 0.85 |
| Example 4C | 60 | 40 | 20 | 16.5 | 12.8 | 3.5 | 91.4 | 0.85 |
| Example 5C | 50 | 50 | 10 | 11.5 | 11.4 | 4.3 | 91.4 | 0.85 |
| Example 6C | 50 | 50 | 20 | 15.8 | 11.6 | 4.4 | 91.3 | 0.86 |
| Comparative Example 1C | 70 | 30 | - | 0.2 | 0.1 | 3.2 | 91.1 | 1.30 |
| Comparative Example 2C | 60 | 40 | - | 0.2 | 0.2 | 3.2 | 91.1 | 1.40 |
| Comparative Example 3C | 50 | 50 | - | 0.1 | 0.1 | 4.3 | 91.1 | 1.40 |

**Table 3-2**

| | Pressure-sensitive adhesive composition (Parts by Mass (Solid content basis)) | | | | | Evaluation Items | | | |
|---|---|---|---|---|---|---|---|---|---|
| | (A) Component | (B) Component | | (C) Component | Tackifier | Adhesive Force | Water Vapor Transmission Rate (g/m²/day) [40°C, 90%RH] | Total Light Transmittance (%) | Haze (%) |
| | Isobutylene-Isoprene Copolymer | SIBSTAR 103T | SIBSTAR 062M | Quinton A100 | I-MARV P-140 | Glass | | | |
| | | Mw. 300,000 Styrene: 30 mass% | Mw: 60,000 Styrene: 20 mass% | Softening Point: 100°C | Softening Point: 140°C | | | | |
| Example 7C | 90 | 10 | - | 10 | - | 11.5 | 3.3 | 91.3 | 0.99 |
| Example 8C | 90 | 10 | - | 30 | - | 11.2 | 3.2 | 91.6 | 0.67 |
| Example 9C | 80 | 20 | - | 10 | - | 12.9 | 3.2 | 91.7 | 0.79 |
| Example 10C | 80 | 20 | - | 30 | - | 12.3 | 3.1 | 91.3 | 0.69 |
| Example 11C | 70 | 30 | - | 10 | - | 12.8 | 3.3 | 91.3 | 0.70 |
| Example 12C | 70 | 30 | - | 30 | - | 12.6 | 3.2 | 91.7 | 0.70 |
| Example 13C | 60 | 40 | - | 10 | - | 12.8 | 3.3 | 91.7 | 0.86 |
| Example 14C | 60 | 40 | - | 30 | - | 12.2 | 3.3 | 91.3 | 0.98 |
| Example 15C | 50 | 50 | - | 10 | - | 12.4 | 3.4 | 91.7 | 1.22 |
| Example 16C | 50 | 50 | - | 30 | - | 13.5 | 3.2 | 91.3 | 1.01 |
| Example 17C | 90 | - | 10 | 10 | - | 11.9 | 3.0 | 91.6 | 0.67 |
| Example 18C | 90 | - | 10 | 30 | - | 12.1 | 3.0 | 91.6 | 0.81 |
| Example 19C | 80 | - | 20 | 10 | - | 10.6 | 3.0 | 91.6 | 0.67 |
| Example 20C | 80 | - | 20 | 30 | - | 13.5 | 2.9 | 91.4 | 0.71 |
| Example 21C | 70 | - | 30 | 10 | - | 10.4 | 2.9 | 91.1 | 0.78 |
| Example 22C | 70 | - | 30 | 30 | - | 13.1 | 2.9 | 91.1 | 0.81 |
| Example 23C | 60 | - | 40 | 10 | - | 9.8 | 2.8 | 91.8 | 0.93 |
| Example 24C | 60 | - | 40 | 30 | - | 16.3 | 2.8 | 91.7 | 0.93 |
| Example 25C | 50 | - | 50 | 10 | - | 9.5 | 2.8 | 91.7 | 1.28 |
| Example 26C | 50 | - | 50 | 30 | - | 16.6 | 2.8 | 91.6 | 1.14 |
| Comparative Example 4C | - | 100 | - | - | - | 0.6 | 5.5 | 91.6 | 1.25 |
| Comparative Example 5C | - | 100 | - | 10 | - | 10.6 | 5.8 | 91.3 | 1.36 |
| Comparative Example 6C | - | 100 | - | 30 | - | 10.2 | 5.2 | 91.2 | 1.39 |
| Comparative Example 7C | - | - | 100 | - | - | 0.6 | 5.3 | 91.1 | 1.29 |
| Comparative Example 8C | - | - | 100 | 10 | - | 14.6 | 5.5 | 91.5 | 1.34 |
| Comparative Example 9C | - | - | 100 | 30 | - | 15.8 | 5.3 | 91.4 | 1.41 |
| Comparative Example 10C | - | - | 100 | - | 30 | 8.8 | 5.3 | 91.4 | 1.41 |
| Comparative Example 11C | 70 | - | 30 | - | 30 | 7.5 | 2.9 | 91.1 | 0.80 |

The pressure-sensitive adhesive sheets of Examples 1C to 26C had excellent adhesive force, high total light transmittance, and low haze, and thus, had good transparency. In addition, since the water vapor transmission rate of the pressure-sensitive adhesive layers is kept low, it is considered that the pressure-sensitive adhesive sheets of Examples 1C to 26C excel in the suppressing effect on moisture intrusion, and can suppress property degradation of an organic EL element or the like.

On the other hand, while keeping the water vapor transmission rate low, the pressure-sensitive adhesive sheets of Comparative Examples 1C to 3C, 11C resulted in poor adhesive force compared to the pressure-sensitive adhesive sheets of the present Examples 1C to 26C.

In addition, since the pressure-sensitive adhesive layers in the pressure-sensitive adhesive sheets of Comparative Examples 4C to 10C resulted in having high water vapor transmission rate compared to the pressure-sensitive adhesive layers in the pressure-sensitive adhesive sheets of Examples 7C to 26C, it is considered that, even when these pressure-sensitive adhesive sheets are used for sealing an organic EL element or the like, the suppressing effect on moisture intrusion is insufficient and therefore it is difficult to suppress property degradation of the organic EL element or the like. In addition, the pressure-sensitive adhesive sheets of Comparative Examples 4C, 7C, 10C resulted in having not only high water vapor transmission rate but also insufficient adhesive force.

### Industrial Applicability

The pressure-sensitive adhesive sheet of the present invention is suitable as a sealing member for electronic devices, for example, organic devices such as an organic transistor, an organic memory, and an organic EL element; liquid crystal displays; electronic paper; thin film transistors; electrochromic devices; electrochemical light-emitting devices; touch panels; solar batteries; thermoelectric conversion devices; piezoelectric conversion devices; electric storage devices; and the like.

In addition, in a manufacturing step of an electronic component, the pressure-sensitive adhesive sheet of the present invention can be applied to the intended use as a temporarily-fixing pressure-sensitive adhesive sheet for temporarily fixing an electronic material having a gas barrier film such as a silicon nitride film and a silicon oxide film, and a conductive film to a glass plate, a substrate or the like, before performing treatment such as etching treatment, washing treatment, heat treatment, exposure treatment, and energy ray irradiation treatment.

### Reference Signs List

1, 1a, 1b, 1c, 1d pressure-sensitive adhesive sheet
11 substrate
12, 12a, 12b pressure-sensitive adhesive layer
13, 13a, 13b release sheet
20 organic EL element
21 glass substrate
22 structure
23 gas barrier film
23a polyethylene terephthalate (PET) film
23b aluminum layer
50 test laminate
51 glass substrate
52 calcium layer

## Claims

1. A pressure-sensitive adhesive composition comprising:
a polyisobutylene-based resin (A) having a mass-average molecular weight of 20,000 or more;
one or more styrene-based copolymers (B) selected from the group consisting of a styrene-butadiene-styrene triblock copolymer (SBS), a styrene-block-(ethylene-co-butylene)-block-styrene triblock copolymer (SEBS), a styrene-isobutylene diblock copolymer (SIB), and a styrene-isobutylene-styrene triblock copolymer (SIBS); and
a tackifier (C) having a softening point of 135°C or less.

2. The pressure-sensitive adhesive composition according to claim 1, wherein the component (C) comprises an aliphatic hydrocarbon resin.

3. The pressure-sensitive adhesive composition according to claim 1 or 2, wherein a softening point of the component (B) is 80 to 200°C.

4. The pressure-sensitive adhesive composition according to any one of claims 1 to 3, wherein a content of the component (B) is 5 to 200 parts by mass with respect to 100 parts by mass of the component (A).

5. The pressure-sensitive adhesive composition according to any one of claims 1 to 4, wherein a content of the component (C) is 5 to 60 parts by mass with respect to 100 parts by mass of the sum of the component (A) and the component (B).

6. The pressure-sensitive adhesive composition according to any one of claims 1 to 5, wherein the component (A) comprises an isobutylene-isoprene copolymer (A1) having a structural unit derived from isobutylene (a1) and a structural unit derived from isoprene (a2).

7. The pressure-sensitive adhesive composition according to claim 6, wherein a content of the structural unit (a2) in the isobutylene-isoprene copolymer (A1) is 0.1 to 30 mol% with respect to all structural units of the component (A1).

8. The pressure-sensitive adhesive composition according to any one of claims 1 to 7, wherein a mass-average molecular weight of the component (B) is 10,000 to 400,000.

9. A pressure-sensitive adhesive sheet having a pressure-sensitive adhesive layer comprising the pressure-sensitive adhesive composition according to any one of claims 1 to 8.

10. The pressure-sensitive adhesive sheet according to claim 9, wherein the pressure-sensitive adhesive sheet has a structure in which the pressure-sensitive adhesive layer is sandwiched between two release sheets.

11. The pressure-sensitive adhesive sheet according to claim 9, wherein the pressure-sensitive adhesive sheet has a substrate and the pressure-sensitive adhesive layer.

12. The pressure-sensitive adhesive sheet according to claim 11, wherein the substrate is a gas barrier film having a substrate for gas barrier and a gas barrier layer.

13. The pressure-sensitive adhesive sheet according to any one of claims 9 to 12, wherein the pressure-sensitive adhesive sheet has total light transmittance of 90% or more.

14. The pressure-sensitive adhesive sheet according to any one of claims 9 to 13, wherein a water vapor transmission rate of the pressure-sensitive adhesive layer under an environment at 40°C and 90% relative humidity is 10.0 g/m²/day or less.

15. The pressure-sensitive adhesive sheet according to any one of claims 9 to 14, for use of sealing an organic EL element.
